# EUROPÄISCHE PATENTSCHRIFT

(11) **EP 0 709 933 B1**
(45) Veröffentlichungstag und Bekanntmachung des Hinweises auf die Patenterteilung: **24.11.1999**
(21) Anmeldenummer: 95113730.6
(22) Anmeldetag: 01.09.1995
(51) Int. Cl.: H01R 9/26, H01R 25/00, H02B 1/052

(54) **Modulare Steuerungsanlage mit Busleiter**
Modular control installation with bus
Installation de réglage avec bus

(30) Priorität: 31.10.1994 DE 4438806
(43) Veröffentlichungstag der Anmeldung: 01.05.1996
(73) Patentinhaber: Weidmüller Interface GmbH & Co., D-32760 Detmold (DE)
(72) Erfinder: Eggert, Gerhard, D-32760 Detmold (DE); Hanning, Walter, D-32758 Detmold (DE); Fiene, Uwe, D-32839 Steinheim (DE); Schnatwinkel, Michael, D-32051 Herford (DE); Steinmeier, Rudolf, D-32760 Detmold (DE); Wilmes, Manfred, D-32760 Detmold (DE); Beins, Eckhard, D-32758 Detmold (DE); Liesenjohann, Matthiass, D-32791 Lage (DE); Schuster, Bernhard, D-32758 Detmold (DE); Wedler, Andreas, D-32689 Kalletal (DE)
(74) Vertreter: Loesenbeck, Karl-Otto, Dipl.-Ing.

(56) Entgegenhaltungen:
- DE-A- 4 303 717

## Beschreibung

Die Erfindung betrifft eine modulare Steuerungsanlage für elektronische Steuerungs- und Automatisierungssysteme gemäß Oberbegriff des Anspruchs 1.

Die Aufgabenstellung einer Steuerungsanlage für elektronische Steuerungs- und Automatiesierungssysteme besteht darin, die Steuerung z. B. für eine Maschine oder Produktionsanlage mit den in der Peripherie verteilten installierten Initiatoren, Aktoren, Feldgeräten oder dergleichen elektrisch zu verbinden.

Bisher erfolgte die elektrotechnische Installation so, daß jeder einzelne Initiator/Aktor/Feldgerät über eine separate Signalleitung mit den im Schaltschrank installierten Eingabe-/ Ausgabekarten der Steuerung direkt zu verbinden war, wobei teilweise an verschiedenen Stellen im Bereich der Maschine oder Produktionsanlage Unterverteilungen in Form von Klemmenkästen installiert wurden. Die Aufgabe dieser Klemmenkästen besteht dabei darin, die vielen im Prozeß verteilten Initiatoren/ Aktoren/Feldgeräte zum Transport der Signale in einen zentralen Schaltschrank zusammenzuführen. Von dem Klemmenkasten aus werden die Kabel über schwere Steckverbinder und eine große Anzahl von Steuerkabeln zum zentralen Schaltschrank der Steuerung verlegt. Hier werden wiederum die einzelnen Leitungen auf die zugehörigen Eingabe-/Ausgabekarten der Steuerung verteilt, so daß jedes ein Signal führende Kabel insgesamt über eine Vielzahl von Verbindungspunkten geführt werden mußte. Diese Art der Verdrahtung ist gleichzeitig material- und installationsintensiv, erfordert einen hohen Planungs- und Dokumentationsaufwand und ist entsprechend fehlerträchtig.

Es sind weiterhin Steuerungsanlagen der gattungsgemäßen Art bekannt, die prozeßnah im Bereich der Klemmenkästen einer Maschine oder Anlage angeordnet sind und für eine Umsetzung der ankommenden und abgehenden Signale der einzelnen Initiatoren/Aktoren/ Feldgeräte auf ein maschinen- bzw. anlagenweites Feldbussystem sorgen. Hierzu ist in der Regel eine räumlich wenig kompakt bauende und vom Funktionsumfang sowie den benötigten Bauelementen weitgehend vorgegebene Anpaßelektronik erforderlich, die eine vorgegebene Anzahl von Eingabe-/Ausgabeanschlußelementen zur Verfügung stellt und diese über die nachgeordnete Elektronik auf ein Feldbussystem umsetzt. Üblicherweise werden Baugruppen gleichartiger Signalschnittstellen als Anschlußblocks in einem Gehäuse angeboten, die 8, 16 oder sogar 32 gleiche Anschlußmöglichkeiten bieten. Vor allem bei gemischter oder nur in geringer bzw. sehr unterschiedlicher Anzahl benötigter Anschlußmöglichkeiten für die vorliegenden Sensoren und Aktoren ist eine Mindestzahl derartiger Baugruppen zu installieren und daher vom Anwender auch zu bezahlen.

Es sind aus der DE 43 03 717 A1 ferner modulare Steuerungsanlagen bekannt, die aus steckbaren Elektronikmodulen und Anschlußmodulen zusammensetzbar sind, wobei die Anschlußmodule Versorgungsleiter- und Signalleiteranschlüsse aufweisen und aus einzelnen Anschlußscheiben zusammengesetzt sind. Dabei sind dem Versorgungsblock einerseits und dem Eingabe-/Ausgabeblock andererseits zugeordnete Anschlußscheiben auch einstückig ausgeführt und einzeln in ein gemeinsames Gehäuse einsetzbar. Weiterhin sind die Versorgungsklemmen und/oder die Eingangs- und Ausgangsklemmen in verschiedenen Anschlußebenen angeordnet. Innerhalb eines Gehäuses sind verschiedene Anschlußkonstellationen der Eingangs- und Ausgangsklemmen durch eine zusätzliche Rangierplatine möglich. Weiterhin ist ein Elektronikblock lösbar mit dem Anschlußblock verbunden, wobei dieser vorzugsweise auf bzw. in dem Anschlußblock auf- bzw. eingesteckt wird und durch zugeordnete Kontakte zwischen Elektronikblock und Anschlußblock elektrisch und mechanisch verbindbar ist. Problematisch an dieser vorgestellten Lösung eines modularen Steuerungssystem ist es, daß eine räumliche Trennung zwischen Versorgungsblock einerseits und dem Eingabe-/ Ausgabeblock andererseits erfolgt, die eine Verdrahtung nur beidseits des räumlich dazwischen angeordneten Elektronikmodules erfordert, wodurch die Zugänglichkeit der Verdrahtungspunkte in vorgegebenen Installationsräumen nicht ausreichend gegeben ist, beispielsweise in engen Klemmenkasten oder vollbelegten Schaltschränken. Auch ist es erforderlich, die Versorgungsklemmen mit Einlegebrücken zu versehen, um das zu einem Block gehörige elektrische Potential zwischen den einzelnen Scheiben des Versorgungs- bzw. Anschlußblockes zu verteilen. Darüber hinaus ist es nicht möglich Initiatoren/ Aktoren/Feldgeräte gleicher Signalform, aber unterschiedlicher elektrischer Versorgungswerte an einem gemeinsamen Anschlußblock zu betreiben, da nur genau eine gemeinsame, quer verteilte Versorgungsspannung an jedem Anschlußblock abzugreifen ist. Durch die Einbettung der einzelnen Anschlußscheiben in ein den gesamten Block umgreifendes Gehäuse ist eine Wartung nur nach Ausbau des gesamten Blockes durch aufwendiges Zerlegen des Anschlußblockes möglich.

Aufgabe der vorliegenden Erfindung ist es daher, eine Steuerungsanlage zur Busankopplung einer Vielzahl verschiedenster Initiatoren, Aktoren, Feldgeräten oder dergleichen an Feldbussysteme zu schaffen, die einen Anschluß an kompakt bauende, modular gestaltete Anschlußblocks bei weitgehender Anpaßbarkeit der Anschlußbaugruppen an die zu lösende Aufgabe der Signalbe- und -verarbeitung des Anwenders, möglichst unter Verwendung vertrauten Installationsweisen bei gleichzeitig einfacher Wartung und Wartbarkeit auch einzelner Zweige der Anschlußbaugruppen gewährleistet und klar gegliederte Verdrahtungsbereiche sowie eine übersichtliche Kabelführung erlaubt.

Die Lösung der erfindungsgemäßen Aufgabe ergibt sich aus den kennzeichnenden Merkmalen des Anspruchs 1.

Erfindungswesentlich für die vorgeschlagene modulare Steuerungsanlage ist es, daß ein strukturierter Aufbau sowohl einer einzelnen Anschlußscheibe aus vorgegebenen Funktionsbereichen in einer festen räumlichen Aufeinanderfolge vorgeschlagen wird, als auch, daß innerhalb jedes Anschlußblocks die funktionsverschiedenen Anschlußscheiben vorgebbar anordnenbar sind. Dabei orientiert sich die für das modulare Steuerungssystem ausgewählte Reihenfolge der Anordnung der Anschlußscheiben auf der Tragschiene und die Anordnung der Funktionsbereiche innerhalb jeder Anschlußscheibe vornehmlich an den Bedürfnissen des Anwenders hinsichtlich eines gut zugänglichen Verdrahtungsbereiches und einer Trennung der Funktionen bezüglich der Anbindung an die Initiatoren/Aktoren/ Feldgeräte od. dgl. und das Bussystem.

Quer zur Erstreckung der die zu einem Anschlußblock aneinandergereihten Anschlußscheiben tragenden Tragschiene wird jede Anschlußscheibe, wenn es von ihrer Funktion her erforderlich ist, in folgender räumlicher Aufeinanderfolge mindestens je einen der folgenden Bereiche innerhalb jeder Anschlußscheibe aufweisen, wobei ein erster Bereich zur Verteilung benötigter elektrischer Potentiale an weitere Anschlußscheiben des selben Anschlußblockes vorgesehen ist, an die ebenfalls die zugeordneten Initiatoren, Aktoren, Feldgeräte od. dgl. direkt anschließbar sind. Die vorgeschlagene Form der Verteilung und des Anschlußes der zugeordneten Initiatoren, Aktoren und Feldgeräte od. dgl. läßt es auch zu, als einen besonderen Vorteil gerade auch die Verteilung unterschiedlicher elektrischer Potentiale innerhalb eines Anschlußblockes zu realisieren, wodurch sich insbesondere Initiatoren, Aktoren, Feldgeräte od. dgl. mit gleichen Funktionen, aber unterschiedlichen elektrischen Anschlußwerten innerhalb eines Anschlußblockes kombinieren lassen. In einem zweiten, dem Verteilungs- und Anschlußbereich räumlich aufeinanderfolgenden Bereich werden vorzugsweise der oder die von den zugeordneten Initiatoren, Aktoren, Feldgeräten od. dgl. zurückkommenden oder abgehenden Signalleiter angeschlossen. Bei verschiedenen Initiatoren/ Aktoren/Feldgeräten wird hier auch deren Versorgungsspannung abgegriffen. Diese ankommenden bzw. abgehenden Signalleiter werden mittels einer in die Anschlußscheibe integrierten Kontaktierung zu einem dritten, wiederum dem Signalleiterbereich nachgeordneten Bereich zur lösbaren Anordnung des Elektronikmodules weitergeleitet werden. Dieser Bereich zur lösbaren Anordnung des Elektronikmodules dient dazu, die elektrisch anliegenden Signale der vorwiegend parallel ausgeführten Anschlußtechnik umzusetzen auf den internen seriellen Busleiter, der innerhalb eines der Tragschiene zugeordneten Bereiches alle Anschlußblockes miteinander und diese ebenfalls mit dem zugeordneten Feldbus verbindet. Der Elektronikmodul stellt dabei unter Bereitstellung aller benötigten Funktionen zur Signalbe- und -verarbeitung die Koppelungsfunktion zwischen den mit den Signalleiteranschlüssen verbundenen Steckanschlüssen und dem diesem räumlich benachbarten Bussystem her.

Dieser strukturierten Aufeinanderfolge von Funktionsbereichen innerhalb einer Anschlußscheibe entspricht die vorgebbare Anordnung der Anschlußscheiben innerhalb eines Anschlußblockes. Jeder Anschlußblock setzt sich vorzugsweise zusammen aus einer Reihung, die an einem Ende mit mindestens einer Schutzleiterscheibe beginnt, vorzugsweise fortgesetzt wird mit mindestens einer Einspeisungsscheibe sowie mindestens einer, vorzugsweise an die Einspeisungsscheibe anschließend angeordneten Versorgungs-/ Signalleiterscheibe. Üblicherweise werden die Anschlußblocks aus einer modulmäßig zusammengesetzen Anzahl von Anschlußscheiben gebildet, wobei sich zur jeweils vorzugsweise mindestens einen Schutzleiterscheibe und Einspeisungsscheibe die dazu notwendige Anzahl von Versorgungs-/ Signalleiterscheiben ergibt. Schutzleiterscheibe und Einspeisungsscheibe können über den Verteilungsbereich mit den Versorgungs-/Signalleiterscheiben verbunden werden und den dort angeschlossenen zugeordneten Initiatoren, Aktoren, Feldgeräten die benötigten Versorgungsspannungen und den Schutzleiteranschluß zur Verfügung stellen. Abschließend kann in einer weiteren bevorzugten Ausführungsform als Abschluß eines Anschlußblockes mindestens eine Rastfußscheibe angeordnet sein.

Besonders vorteilhaft an der bevorzugten räumlichen Aufeinanderfolge der Anschlußscheiben innerhalb eines Anschlußblocks bzw. der Funktionsbereiche innerhalb einer Anschlußscheibe ist es, daß sich für den Anwender eine klare, in jedem Anschlußblock wiederholbare Reihenfolge der Funktionselemente ergibt, und die für die Installation der Initiatoren, Aktoren, Feldgeräte od. dgl. wichtigen Versorgungs-/Signalleiterbereiche eine gute Zugänglichkeit innerhalb eines zusammenhängenden Installationsbereiches erlaubt. Der Anschluß der auch unterschiedlichen Potentiale der Versorgungsspannungen und -ströme wird sehr flexibel auch kabellos durch vorgefertigte Bauelemente gelöst, an die wiederum direkt die Kabel der Initiatoren/Aktoren/Feldgeräte angeschlossen werden können. Hiermit wird die dem Anwender von der bekannten Technik der Reihenklemme vertraute Vorgehensweise auf die neuen Möglichkeiten der Anbindung an ein Bussystem übertragen, wodurch vor allen Dingen auch aufgrund der klar gegliederten Verdrahtungsbereiche eine übersichtliche Kabelführung erzielbar ist. Der modulare, aus Anschlußscheiben bestehende Aufbau eines Anschlußblockes erlaubt es weiterhin, während der Installation zu Testzwecken und auch bei später eventuell notwendigen Fehlersuchen und Wartungen direkt auf einzelne Zweige und Bereiche der Anschlußbaugruppen zuzugreifen und diese klar voneinander zu trennen.

Der Aufbau der einzelnen Anschlußscheiben aus räumlich aufeinanderfolgenden Funktionsbereichen ermöglicht es, für jede der funktionsverschiedenen Anschlußscheiben nur diejenigen Bereiche gehäuseseitig vorzusehen bzw. elektrotechnisch und mechanisch zu bestücken, die tatsächlich für die jeweilige Funktion benötigt werden. Hierdurch ist es möglich, mit nur wenigen Anschlußscheibenbauformen bzw. gleichen Bauformen der Anschlußscheiben bei unterschiedlicher Bestückung sehr viele verschiedene, für die Steuerungsanlage benötigte Einzelfunktionen zu realisieren. Ebenfalls von großem Vorteil, vor allem auch im Bezug auf eine problemlose Wartung und den Austausch defekter Komponenten ist es, daß der Elektronikbereich zur Be- und Verarbeitung der Signale zentral innerhalb des lösbar und steckbar ausgeführten Elektronikmodules zusammengefaßt ist, wodurch ein schneller Austausch einer derartigen Einheit bzw. auch die Anpassung der Funktionen jedes Elektronikmoduls an die Funktionalität jeder Anschlußbaugruppe möglich ist.

Eine vorteilhafte Ausführungsform einer Schutzleiterscheibe weist einen mechanischen und elektrischen Anschluß zur Tragschiene und einen Steckanschluß zum Elektronikmodul auf, wobei die Schutzleiterscheibe keinen Anschluß für den internen Busleiter benötigt und dieser Bereich in vorteilhafter Weise auch gehäuseseitig freibleibend ausgeführt ist. Die Schutzleiterscheibe kann in vorteilhafter Weise mit der Potentialverteilung an weitere Anschlußscheiben des selben Anschlußblocks verbindbar sein.

Eine erfindungsgemäße Einspeisescheibe weist zum einen einen gehäuseseitig vorgesehenen Bereich für die Aufnahme des internen Busleiters auf und ist mit der Potentialverteilung an weitere Anschlußscheiben desselben Anschlußblocks und dem Elektronikmodul verbindbar. An der Einspeisescheibe sind also die Versorgungsspannungen sowohl für die Verteilung an die Initiatoren, Aktoren, Feldgeräte od. dgl. des Anschlußblockes als auch des Elektronikmoduls anschließbar. Auch ist es in einer vorteilhaften Ausführungsform möglich, eine Einspeisescheibe mit nur einer Versorgungs-/Signalleiterscheibe innerhalb eines Anschlußblockes elektrisch leitend zu verbinden oder an einer Einspeisescheibe nur eine Verbindung ausschließlich zur Versorgung des Elektronikmoduls vorzusehen.

Eine Versorgungs-/Signalleiterscheibe zum Anschluß der zugeordneten Initiatoren, Aktoren, Feldgeräte od. dgl. besteht aus einem Bereich, in dem auch querverteilende Verteilerleisten angeordnet werden können, einem Bereich mit mindestens einer Signalleiterklemme, den Steckanschlüssen für den Elektronikmodul und dem gehäuseseitig vorgesehenen Bereich für die Aufnahme des internen Busleiters. In die Vorrichtungen zur Aufnahme von Verteilerleisten werden in diese rastbar angeordnete, auch querverteilende Anschlußelemente eingesteckt, die zu Verteilerleisten aneinanderreihbar sind und an die die Versorgungskabel für die Initiatoren, Aktoren, Feldgeräte od. dgl. angeordnet werden können. Für eine gute Übersichtlichkeit der Verteilung der Potentiale können diese Anschlußelemente in vorteilhafter Weise farbig ausgeführt werden. Zur Verrastung der Anschlußelemente bzw. Verteilerleisten weisen die Vorrichtungen zur Aufnahme von Verteilerleisten Befestigungskonturen auf, die mit entsprechenden Gegenkonturen der Anschlußelemente zusammenwirken.

In einer weiteren bevorzugten Ausführungsform können in die Vorrichtungen zur Aufnahme von Verteilerleisten Elemente eingesteckt werden, die die elektrische Querverbindung der angereihten Anschlußelemente innerhalb der Verteilerleiste an dem jeweiligen Einsteckplatz unterbrechen und es somit ermöglichen, auch innerhalb einer durchgehenden Verteilerleiste unterschiedliche elektrische Potentiale aufzulegen. Es kann darüberhinaus auch mehr als ein derartiges Element vorgesehen oder eine mit einem solchen Element versehene Verteilerleiste mit einem Brückerelement kombiniert werden.

Zur mechanischen Befestigung jedes Anschlußblockes an der Tragschiene weist jeder Anschlußblock vorzugsweise an den beiden Anschlußscheiben am Anfang und am Ende des Druchtritts der Tragschiene durch den Anschlußblock derart ausgeführte Anschlußscheiben auf, daß jeweils der Tragschiene zugeordnete Rastfüße zur mechanischen Klemmung auf und/oder elektrischen Verbindung mit dieser Tragschiene vorhanden sind. Hierdurch wird der Anschlußblock mechanisch sicher auf der Tragschiene befestigbar und gleichzeitig ein Anschluß an die üblicherweise als Schutzleiter weiter verbundene Tragschiene realisiert. Durch die beidseitige Anordnung von Rastfüße aufweisenden Anschlußscheiben ist es möglich, dazwischen angeordnete Anschlußscheiben auch ohne direkten mechanischen Kontakt mit der Tragschiene zwischen diesen beiden Anschlußscheiben anzureihen.

Eine derartig gestaltbare Rastfußscheibe kann zum einen ausschließlich eine mechanische Verbindung zur Tragschiene aufweisen, auch kann eine derartige Rastfußscheibe zusätzlich die Funktion einer Schutzleiterscheibe aufweisen, wobei diese Schutzleiterscheibe dann zum ausschließlichen Anschluß eines separaten Schutzleiters an dem Elektronikmodul vorsehbar ist. Auch ist es möglich, eine derartige Rastfußscheibe als zweite Einspeisescheibe zum ausschließlichen Anschluß eines Digitalausgabemodules und/oder des Elektronikmodules auszubilden, wodurch eine getrennte Spannungsversorgung derartiger digitaler Ausgabemodule und des Elektronikmodules auch dann möglich ist, wenn z. B. bei Störungen die Spannungsversorgung der anderen Initiatoren, Aktoren, Feldgeräte od. dgl. nicht mehr gewährleistet ist. Dies dient dazu, auch im Störungsfall digitale Ausgabemodule und den Elektronikmodul den Sicherheitsrichtlinien entsprechend abschalten zu können.

Werden zwei Schutzleiterscheiben innerhalb eines Anschlußblockes angeordnet, so sind diese in der Reihung am Anfang und am Ende des Anschlußblockes vorsehbar.

In einer besonders vorteilhaften Ausführungsform ist es möglich, gleichartige Initiatoren, Aktoren, Feldgeräte od. dgl. nach Bedarf in Anschlußblocks gleichartiger Versorgungs-/ Signalleiter zusammenzufassen oder die Anschlußblocks aus funktionell gemischt aufgebauten Versorgungs-/Signalleiterscheiben zu bilden. Durch diese Reihungsmöglichkeit gleicher oder verschiedenartiger Versorgungs-/Signalleiterscheiben innerhalb eines Anschlußblockes können zum einen für eine übersichtliche Installation Zusammenfassungen funktionell gleicher Sensoren gewählt werden, wobei bei Bedarf jedoch auch nach der lokalen Anordnung der Initiatoren, Aktoren, Feldgeräte od. dgl. gegliederte Anschlußblocks gebildet werden können.

In einer weiteren, besonders vorteilhaften Ausführungsform wird der interne Busleiter, der innerhalb des vom Gehäuse gebildeten Bereiches angeordnet ist, aus Busschienenstücken zusammengesetzt, die über verschiebbare und rastbare Trennschieber lösbar und elektrisch/mechanisch mit den benachbarten Busleiterstücken verbindbar sind. Eine derartige segmentweise Zusammensetzung des Busleiters aus Busschienenstücken ermöglicht es, z. B. bei der Wartung einzelne Anschlußblocks durch Auskoppeln aus dem Busleiter elektrisch und mechanisch vom Busleiter zu trennen und diese dann auch separat von der Tragschiene abzurasten. Hierzu wird der im Bereich nebeneinander angeordneter Anschlußblocks freie Busleiterbereich jeweils Schutzleiterscheibe und der Rastfußscheibe genutzt, um einen Eingriffsraum für die mechanische Abrastung des Anschlußblockes von der Tragschiene zu bilden.

Die im Bereich des Busleiters nicht ausgebildeten Gehäuse der Schutzleiterscheibe und der Rastfußscheibe ermöglichen es weiterhin, diesen freibleibenden Bereich als Betätigungszone für die Trennschieber zur Ankopplung an benachbarte Busleiterstücke zu nutzen, wobei zum einen die Trennschieber auf der von der Tragschiene abgewandten Seite verdeckt sind, solange der Elektronikmodul in seinem Steckplatz befestigt ist und zum anderen die Schutzleiterscheibe bzw. die Rastfußscheibe erst nach dem Abnehmen des Elektronikmodules abrastbar ist. Hierdurch wird verhindert, daß ein Anschlußblock versehentlich abgerastet werden kann, der noch elektrisch mit dem Bussystem verbunden ist.

An einem Ende des Busleiters ist ein Anschlußmodul zur Ankopplung des der Tragschiene zugeordneten Busleiters an ein zugeordnetes Feldbussystem vorgesehen, wobei an dem dem feldbusseitigen Ende abgewandten Ende des internen Busleiters eine steckbare Abschlußscheibe mit Abschlußwiderständen des internen Busleiters vorsehbar ist, die vorzugsweise als Steckschuh mit einer an der internen Busleiterplatine angeordneten Platine ausführbar ist, die wiederum die Abschlußwiderstände zwischen den einzelnen Busleiterbahnen trägt.

Zur Kopplung der Signalleiter mit dem internen Busleiter weist jedes Elektronikmodul mindestens je einen steckbaren und lösbaren Steckanschluß auf der einen Seite mit den den Signalleitern zugeordneten elektrischen Verbindungselementen und zum anderen mit dem internen Busleiter auf, wobei diese Steckanschlüsse über Funktionsleiterplatten miteinander verbunden sind, auf denen die Signalbe- und -verarbeitung stattfindet.

In einer vorteilhaften Ausführungsform ist jedem Anschlußblock mindestens je ein Elektronikmodul zugeordnet, wobei je nach Anwendungsfall auch die Zuordnung von mehr als einem Anschlußblock zu einem Elektronikmodul oder von mehreren Elektronikmodulen je Anschlußblock denkbar ist. Beim Anschluß passiver Initiatoren/Feldgeräte, deren Versorgungsanschlüsse gleichzeitig ein auswertbares Signal zur Verfügung stellen, können die Vorrichtungen zur Aufnahme von Verteilerleisten der zugeordneten Versorgungs-/Signalleiterscheibe entfallen, wobei dann mindestens zwei Signalleiteranschlüsse vorgesehen sind. Beim Anschluß aktiver Initiatoren/Feldgeräte muß immer mindestens eine Vorrichtung zur Aufnahme von Verteilerleisten und mindestens je ein Signalleiteranschluß vorgesehen sein, um die auf dem Signalleiter zurückkommenden Signale an den Elektronikmodul weiterleiten zu können.

Der Elektronikmodul weist ein mindestens eine Anschlußscheibe umgreifendes Gehäuse auf, das die in mindestens einem Anschlußblock aneinandergereihten Anschlußscheiben stabilisiert und veränderbar codierbar ist. Damit hat das Gehäuse des Elektronikmodules zusätzlich zu den Rastfußscheiben auch die Funktion der mechanischen Kopplung der aneinandergereihten Anschlußscheiben, wobei durch die Codierung eine Fehlanordnung des Elektronikmoduls verhindert wird. Ist ein Elektronikmodul mehr als einem Anschlußblock zugeordnet, so kann sein Gehäuse auch mehr als die Scheiben eines Anschlußblockes umgreifen. An vorzugsweise jeder Anschlußscheibe sind Formelemente zur Verrastung des Elektronikmoduls vorhanden, die vorzugsweise als federnde Rasthaken ausgebildet sind und die beim Aufsetzen des Elektronikmodules korrespondierende Ausnehmungen des Gehäuses des Elektronikmoduls durchdringen, wobei vorzugsweise nur ein Teil dieser Ausnehmungen mit den Rasthaken zusammenwirkende Rastelemente vorgesehen sind. Hierdurch werden die Betätigungskräfte beim Stecken und Abnehmen des Elektronikmodules begrenzt. Zusätzlich ist an jeder Anschlußscheibe ein federnder Rasthaken vorgesehen, wobei nur einer in eine entsprechende Ausnehmung an der Rückseite des Elektronikmoduls eingreift. Hierdurch wird gewährleistet, daß ein Lösen des Elektronikmoduls nur mittels Werkzeug möglich ist. Ebenfalls ist an jeder Anschlußscheibe an mindestens einer Führungsfläche für den Elektronikmodul eine Anzahl von Formelementen vorsehbar, mit denen der Elektronikmodul beim Einstecken geführt wird und die vorzugsweise in Form von T-Nuten ausgebildet sind. Mit den in jeder Anschlußscheibe ausgeführten T-Nuten oder Teilen von T-Nuten korrespondieren Formelemente am Gehäuse des Elektronikmoduls, wobei vorzugsweise nur zwei derartige Formelemente mit den T-Nuten der Anschlußscheiben tatsächlich vorgesehen und in Eingriff gebracht werden. Auch hierdurch wird ein geführtes Einstecken des Elektronikmodules erreicht, ohne das es zu einem Verklemmen aufgrund einer zu hohen Anzahl von Fügestellen kommt.

Eine bevorzugte Form der Codierung des Gehäuses des Elektronikmodules ist es, an der an der offenen Seite des Gehäuses angeordneten, umlaufenden Kante eine Höhenabstufung anzubringen, so daß das Gehäuse nur in einer Orientierung in den Steckplatz des Elektronikmodules einsteck- bzw. aufsteckbar ist.

Von besonderer Vorteilswirkung ist es weiterhin, daß beim Entfernen eines Elektronikmodules von einem oder von mehreren der zugeordneten Anschlußblocks durch den weiterhin verbundenen Busleiter die restlichen an der Tragschiene angeordneten Anschlußblocks voll funktionsfähig bleiben.

In einer vorteilhaften Ausführungsform ist zum Anschluß der Abschirmungen der zugeordneten Anschlußkabel eine längenanpaßbare Sammelschiene auf die Schutzleiterscheibe und eine weitere Rastfußscheibe des gleichen oder eines weiteren Anschlußblocks aufsteckbar, die durch Kontakte der Schutzleiterscheibe einen elektrischen Anschluß zur Tragschiene hat und an die an den benötigten Stellen auf der Sammelschiene mittels ebenfalls aufrastbarer Klemmstücke die jeweils herausgeführte Schirmung des dort einkommenden Anschlußkabels klemmbar ist.

Der Anschluß aller Leiter auf der Versorgungs-/Signalleiterseite erfolgt von der der Tragschiene abgewandten Seite, wobei bei vorgenommenen Verdrahtung der Elektronikmodul auch ohne Lösen der Verdrahtung in Form einer sogenannten stehenden Verdrahtung abnehmbar ist.

Zur Kennzeichnung der einzelnen Anschlüsse an den Anschlußblocks ist zusätzlich zum Aufbringen jeweils direkt an den Anschlußscheiben, vorzugsweise als steckbare Beschriftungen, eine oder mehrere große Markierungsflächen durch ebenfalls steckbare Beschriftungsdeckel und/oder schwenkbare Schildträger oberhalb der Verdrahtungsebene vorsehbar.

Die gute Zugänglichkeit zur Verdrahtungsebene im Bereich des Anschlußes der Versorgungsleiter ist auch dadurch gewährleistet, daß die Versorgungsleiteranschlüsse parallel zur Ebene der Tragschiene auf gleichem Höhenniveau liegen und daher gleichmäßig gut zugänglich sind.

Besonders vorteilhafte Ausführungsformen des erfindungsgemäßen modularen Steuerungssystems zeigt die folgende Zeichnung.

Es zeigen:
- Figur 1: eine Gesamtansicht des modularen Steuerungssystems mit einem Anschlußblock, einem Elektronikmodul und dem Feldbusanschlußmodul,
- Figur 2: eine Schnittdarstellung des Gehäuses des Elektronikmoduls im gesteckten Zustand auf den Bereich des Busleiters eines Anschlußblockes,
- Figur 3: eine Darstellung des modularen Steuerungssystems mit Feldbusanschlußmodul, drei Anschlußblocks sowie daran angeschlossenen Initiatoren, Aktoren, Feldgeräten od. dgl. mit Ausbildung der Anschlußscheiben für digitale Eingänge,
- Figur 4: eine Darstellung von Anschlußblocks gemäß Figur 3 mit Darstellung zweier Anschlußblocks mit Ausbildung der Anschlußscheiben für digitale Ausgänge,
- Figur 5: eine Schutzleiterscheibe in der Seitenansicht mit daran angeordnetem Busleiterbereich und Elektronikmodul,
- Figur 6: eine Einspeisescheibe in der Seitenansicht mit daran angeordnetem Busleiterbereich und Elektronikmodul,
- Figur 7: eine Versorgungs-/Signalleiterscheibe in der Seitenansicht mit daran angeordnetem Busleiterbereich und Elektronikmodul,
- Figur 8: eine Rastfußscheibe in der Seitenansicht mit daran angeordnetem Busleiterbereich und Elektronikmodul,
- Figur 9: eine Einspeisescheibe in der Seitenansicht mit daran angeordnetem Busleiterbereich und Verbindung eines Versorgungsanschlusses zum Elektronikmodul,
- Figur 10: eine Rastfußscheibe in der Seitenansicht mit einer Verbindung zwischen Signalleiteranschluß und Elektronikmodul,
- Figur 11: eine Rastfußscheibe mit integrierten Schutzleiteranschluß des Elektronikmoduls,
- Figur 12: eine Versorgungs-/Signalleiterscheibe mit daran angeordnetem Busleiterbereich und Elektronikmodul in der Seitenansicht sowie aufgesteckter Sammelschiene mit Kontaktierungsblech auf Stecksockel zur Anbringung einer Schirmung,
- Figur 13: eine Schutzleiterscheibe mit daran angeordnetem Busleiterbereich und Elektronikmodul in der Seitenansicht sowie dem Stecksockel zur Befestigung einer Sammelschiene sowie Verbindungselementen zur Tragschiene,
- Figur 14: eine Vorderansicht eines Anschlußblocks mit daran angeordnetem Kontaktierungsblech auf Stecksockel und federnd aufsteckbaren Kabelklemmschuhen,
- Figur 15: T-Nutenanordnung an den Anschlußscheiben jedes Anschlußblockes sowie darin eingestecktem T-nutenförmigen Ansatz am Gehäuse des Elektronikmoduls,
- Fig.16a-c: Prinzipaufbau einer Abschlußscheibe zur Anbringung von Widerständen am Ende des internen Busleiters.
- Figur 17: Anordnung von Rasthaken zwischen Anschlußscheiben und Gehäuse des Elektronikmoduls zur Sicherung des Gehäuses gegen Abziehen
- Figur 18: Anordnung von Trennelementen zur Potentialtrennung innerhalb einer Verteilerleiste

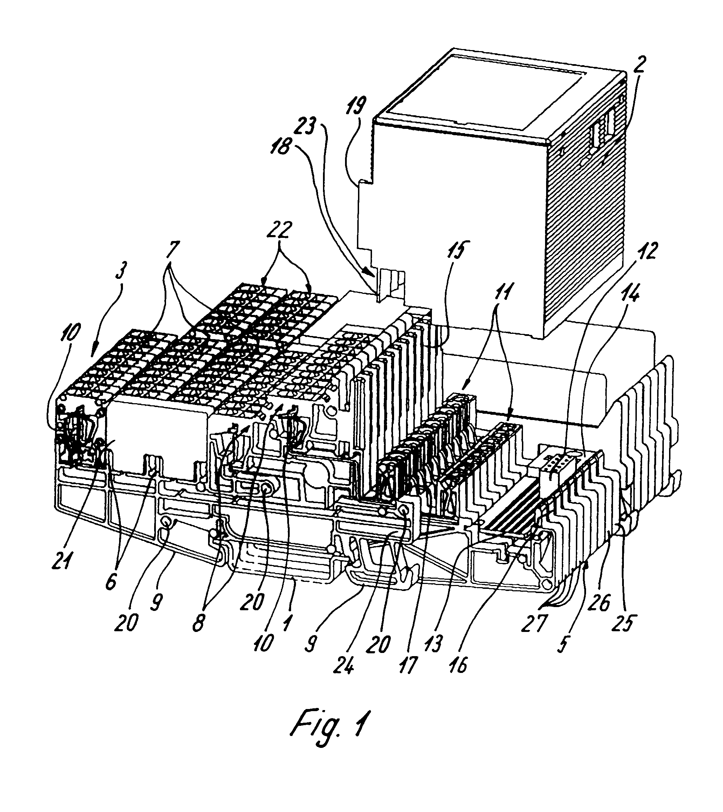

Die Figur 1 zeigt eine Gesamtdarstellung eines modularen Steuerungssystems, wobei hier ein aus einzelnen Anschlußscheiben 24-27 gebildeter Anschlußblock 3 direkt an einem Feldbusanschlußmodul 4 angeordnet ist und auf den Anschlußblock 3 ein Elektronikmodul 2 vertikal aufsteckbar ist.

Der Anschlußblock 3 besteht aus einer Reihung einer Schutzleiterscheibe 25, einer Einspeisescheibe 26, sowie einer Anzahl von Versorungs-/ Signalleiterscheiben 27 und wird abgeschlossen durch eine Rastfußscheibe 24. Im vorderen Bereich des Anschlußblockes 3 ist in den drei dargestellten Vorrichtungen zur Aufnahme von Verteilerleisten 6 eine Anzahl von zu Verteilerleisten gereihten Anschlußelementen 7 aufgesteckt, die elektrische Potentiale, die an der Einspeisescheibe 26 in den Anschlußblock 3 eingespeist werden, zu anderen Anschlußscheiben des gleichen Anschlußblocks 3 querverteilt. Diese Anschlußelemente 7 sind ebenfalls zum Anschluß der Versorgungsleitungen der zugeordneten Initiatoren, Aktoren, Feldgeräte od. dgl. vorgesehen. Hierzu sind die Anschlußelemente 7 mit Verbindungselementen 10 zum hier als Einstecksystem ausgeprägten schraubenlosen Klemmen der Versorgungskabel ausgestattet, wobei die Kabel in einer vertikalen Richtung in die Anschlußelemente 7 eingesteckt werden. An dieser Stelle können natürlich auch andere bekannte Anschlußarten (z.B. Schraubanschluß, Steckanschluß) mit unterschiedlichen Leiteranschlußrichtungen und Betätigungsrichtungen vorgesehen sein.

Direkt neben den Vorrichtungen zur Aufnahme von Verteilerleisten 6 sind die Signalleiteranschlüsse 8 angeordnet, die in diesem Fall zweireihig zwei verschiedene Signalleiter zugeordneter Initiatoren, Aktoren, Feldgeräte od. dgl. anschließbar machen. Diese Signalleiteranschlüsse 8 sind hier z.B. ebenfalls mit Verbindungselementen 10 der vorstehenden Art ausgerüstet, so daß auch hier die Signalleiterkabel vertikal von oben in die Signalleiteranschlüsse 8 eingesteckt werden können. Die beiden Signalleiteranschlüsse 8 sind in vertikaler Richtung versetzt zueinander angeordnet, so daß sich eine treppenförmige Anordnung ergibt und die Zuordnung der Signalleiteranschlüsse 8 zu den Signalleitern einfacher wird.

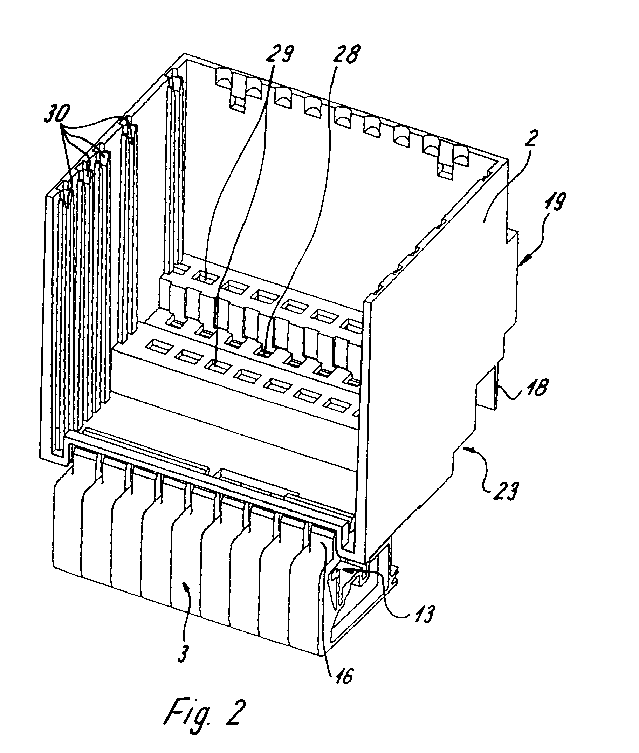

An die Signalleiteranschlüsse 8 anschließend ist der Steckplatz für den Elektronikmodul 2 ausgeführt, der aus einer Anzahl von mechanischen Führungs- und Verrastungselementen sowie elektrischen Steckverbindern besteht. Das in der Figur 2 in einer Schnittdarstellung ausführlicher dargestellte Gehäuse des Elektronikmoduls 2 ist im wesentlichen aus rechteckig angeordneten Wandungselementen aufgebaut, wobei an den Außen- und Stoßkanten der Wandungselemente Führungs- und Verrastungselemente zur mechanischen Befestigung des Gehäuses an dem Anschlußblock vorgesehen sind. Zum einen ist eine Führungsfläche 15 mit später noch genauer dargestellten T-Nuten- förmigen Führungselementen vorgesehen, die an der den Versorgungs- und Signalleiteranschlüssen zugewandten Seite des Gehäuses mit korrespondierenden T-Nuten-Gegenstücken 19 in Eingriff gebracht werden können, indem das Elektronikmodul 2 vertikal von oben in diese T-Nutenförmigen Führungen 15 eingesteckt wird. Zur Führung bei diesem Einsteckvorgang ist in Verlängerung der den Führungsflächen 15 zugeordneten Gehäusewandung eine Anzahl von Führungszungen 18 ausgeführt. Diese Führungszungen 18 hintergreifen die anschließend an die Führungsfläche 15 angeordneten Steckanschlüsse 11.

Auf der den Versorgungs- und Signalleiteranschlüssen abgewandten Seite des Anschlußblockes sind Führungslaschen 16 angeordnet, die mit der ebenfalls den Versorgungs- und Signalleiteranschlüssen abgewandten Seite des Gehäuses des Elektronikmodules 2 zusammenwirken und ebenfalls eine Führung des Gehäuses 2 beim Aufstecken auf den Anschlußblock 3 bewirken. Diesen beidseitig am Anschlußblock 3 bzw. am Gehäuse des Elektronikmoduls 2 angeordneten Führungselemente 18 und 16 ist eine Anzahl von Rasthaken 17 zur Befestigung des Gehäuses 2 zugeordnet, die in noch näher dargestellter Weise innerhalb des Gehäuses des Elektronikmodules 2 an jeder Anschlußscheibe angeordnet sind und mit innerhalb des Gehäuses 2 angeordneten Ausnehmungen 28 zusammenwirken. Durch diese Rasthaken 17 wird das Gehäuse des Elektronikmodules 2 in der montierten Stellung am Anschlußblock 3 verrastet und somit in vertikaler Richtung festgelegt.

Innerhalb der vom Gehäuse des Elektronikmodules 2 umschlossenen Bauraumes werden über Steckverbindungen 11 zum Anschluß der Signalleiter 8 an den Elektronikmodul 2 sowie den Steckverbinder 12 zur Verbindung des internen Busleiters 13 mit dem Elektronikmodul 2 alle elektrischen Kontakte hergestellt, die den Anschlußblock 3 mit dem Elektronikmodul 2 verbinden müssen. Der Elektronikmodul 2 ist also durch einfaches vertikales Aufstecken sowohl mit dem Anschlußblock 3 und den an diesen Anschlußblock 3 klemmenseitig anliegenden Signalen und Versorgungsspannungen verbunden als auch mit dem internen Busleiter 13, der die Verbindung einer Reihung von Anschlußblocks 3 mit dem Feldbusanschlußmodul 4 herstellt. Die beiden Reihen 11 der Steckanschlüsse zur Verbindung des Elektronikmoduls 3 mit den Signalleitern 8 beinhalten in der Schutzleiterscheibe 25, der Einspeisescheibe 26 und gegebenenfalls in der Rastfußscheibe 24 Funktionen zur Versorgung des Elektronikmodules 3 mit benötigten elektrischen Potentialen sowie der Verbindung mit dem Schutzleiter. Hierzu werden die jeweiligen Anschlußscheiben 24,25,26 in der benötigten Weise elektrisch mit anderen Bestandteilen des Anschlußblockes 3 verbunden. Innerhalb der Versorgungs-/Signalleiterscheibe sind die Signalleitersteckanschlüsse 11 mit den Signalleiteranschlüssen 8 elektrisch leitend verbunden, so daß die über die Signalkabel einlaufenden Signale auch an den Steckanschlüssen 11 anliegen. In die Steckanschlüsse 11 werden innerhalb des Gehäuses des Elektronikmodules 2 angeordnete, hierfür vorbereitete Funktionsleiterplatten 40 eingesteckt, so daß auf den Funktionsleiterplatten 40 angeordnete Kontakte mit den Steckanschlüssen 11 eine elektrische Verbindung herstellen. Ein weiterer Steckanschluß 12 besteht innerhalb des Gehäuses des Elektronikmodules 2 mit dem Busleiter 13, vorzugsweise in Form eines Platinensteckverbinders 12, der hier alle benötigten Verbindungen innerhalb eines Steckerblockes bereitstellt. Von diesen Platinensteckverbinder 12 werden die Kontakte auf die Leiterbahnen des internen Busleiters 13 verteilt und von dort auf das Feldbusanschlußmodul 4 bzw. weitere Busleiterbereiche 13 an einer Tragschiene 1 weitergeleitet.

In Verlängerung der Tragschiene 1 sitzt an dem Anschlußblock 3 das Feldbusanschlußmodul 4, das wiederum scheibenförmig aufgebaut ist und neben der Anschaltelektronik für den Feldbus auch Anschlußelemente 22 zur elektrischen Versorgung des Feldbusanschlußmodules 4 sowie zur Verteilung von elektrischen Potentialen an nachgeordnete Anschlußblocks 3 beinhaltet. Innerhalb des Feldbusanschlußmodules 4 werden die Signale des internen Busleiters 13 so be- bzw. verarbeitet, daß beispielsweise an mehreren Tragschienen 1 angeordnete Anschlußblocks 3 miteinander verbindbar sind oder Signale an eine übergeordnete Auswertestelle weitergemeldet werden.

Der Anschlußblock 3 wird gebildet aus der schon genannten Anzahl von Anschlußscheiben 24 bis 27, wobei die Anschlußscheiben des Anschlußblockes 3 durch Reihung mittels formschlüssiger Elemente 20, hier vorzugsweise als Anreihbolzen und -bohrung ausgeführt, gegeneinander gesichert sind. Die Befestigung des Anschlußblockes 3 an der Tragschiene 1 erfolgt mittels Rastfüßen 9, die zum einen in der Schutzleiterscheibe 25, zum anderen auf der Rastfußscheibe 24 angeordnet sind und mit denen die Rastfüße 9 auf der Tragschiene 1 geklemmt werden. Das Einrasten erfolgt in bekannter Weise durch Einhängen einer Seite des Anschlußblockes 3 an der Tragschiene 1 und dem Verrasten durch Niederdrücken in vertikaler Richtung, wobei ein beweglicher Rastfuß 9 federnd zurückweicht und im eingerasteten Zustand die Tragschiene 1 hintergreift.

Zum Abrasten eines Anschlußblockes 3 wird nach dem Abnehmen des Elektronikmoduls 2 und dem Auftrennen des aus Busleiterstücken zusammengesetzten Busleiters 13 mittels Trennschiebern 14 mit einem geeigneten Werkzeug in den freien Bereich der zurücktretenden Schutzleiter- und Rastfußscheibe 24 bzw. 25 unter den Anschlußblock 3 gefaßt und dieser nach oben abgehebelt. Durch die formschlüssigen Anreihbolzenverbindungen 20 zwischen den einzelnen Anschlußscheiben 24-27 werden nicht nur die Rastfußund die Schutzleiterscheibe 24 und 25 angehoben, sondern alle zwischen diesen beiden Anschlußscheiben frei angeordneten Versorgungs- und Einspeisungsscheiben 27 ebenfalls mit nach oben abgehoben.

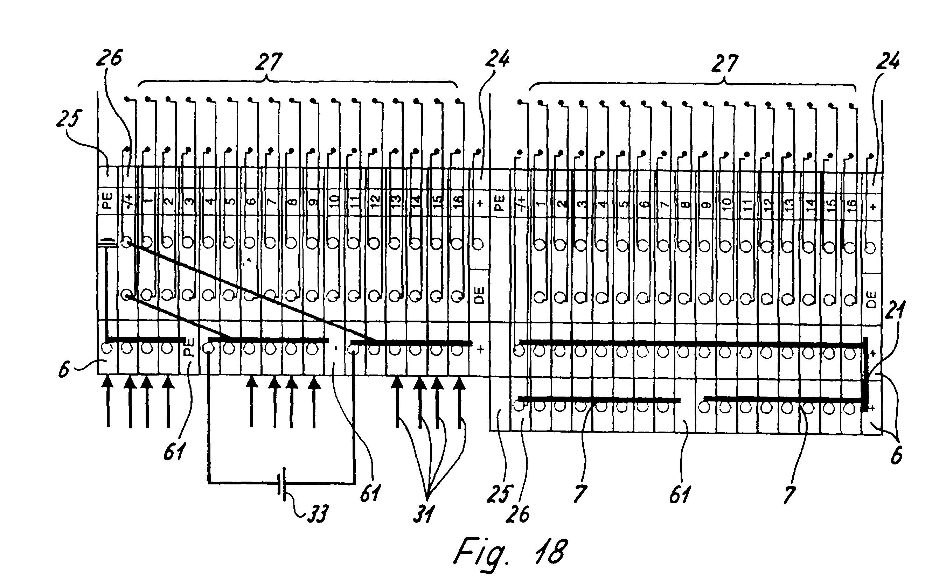

Auf der Seite der Vorrichtungen zur Aufnahme von Verteilerleisten 6 des Anschlußblockes 3 ist ein Brückenelement 21 vorgestehen, das eine Verteilung eines elektrischen Potentials auf zwei in benachbarten Vorrichtungen zur Aufnahme von Verteilerleisten 6 steckbar angeordneten Anschlußelementen 7 ermöglicht. Hierzu wird das Brückenelement 21, das aus zwei quer zur Reihung aneinander befestigten Anschlußelementen 7 aufgebaut ist, von oben in die benachbarten Vorrichtungen zur Aufnahme von Verteilerleisten eingesteckt, wobei im Inneren des Brückenelementes 21 eine elektrische Verbindung der in den beiden Verteilerleisten angereihten Anschlußelemente 7 vorgesehen ist. Hierdurch können auch innerhalb einer Verteilerleiste verschiedene Potentiale quer verteilt werden, solange keine direkte Verbindung zwischen den beiden Potentialen durch eine Brückung innerhalb einer Vorrichtung zur Aufnahme einer Verteilerleiste erfolgt. Dies wird durch die in der Figur 18 noch näher erläuterten Trennelemente erreicht.

In der Figur 2 ist in einer Schnittdarstellung das Innere des Gehäuses des Elektronikmodules 2 dargestellt, wobei zur besseren Übersichtlichkeit die Funktionsleiterplatinen 40 entfernt wurden. Man blickt in der Figur 2 aus Richtung des Bereiches des Anschlußblockes 3 in das Gehäuse des Elektronikmodules 2, der dem Busleiter 13 zugeordnet ist. Angedeutet sind die busleiterseitigen Bereiche 13 der Anschlußscheiben 24-27 des Anschlußblockes 3. Auf der nicht sichtbaren Rückseite erkennt man ansatzweise die T-Nuten-Gegenstücke 19 sowie die Führungszungen 18, die an den Anschlußblock 18 anliegen. Im unteren Bereich, also den Anschlußscheiben 24-27 des Anschlußblockes 3 zugewandt, ist das Gehäuse 2 höhenabgestuft ausgeführt, wobei dies in Form einer treppenförmigen Abstufung 23 erfolgt. Diese treppenförmige Abstufung 23 dient dazu, das Gehäuse des Elektronikmodules 2 in nur einer Orientierung auf den Anschlußblock 3 aufstecken zu können, um damit eine Vertauschung oder Verwechslung verschiedener elektrischer Kontakte durch falsches Aufstecken des Elektronikmodules auszuschließen.

Auf der dem Versorgungs- und Signalleiterbereich abgewandten Seite des Anschlußblockes 3 sind erneut die Führungslaschen 16 zu erkennen, die mit einer nutförmig ausgeführten Vertiefung des Gehäuses 2 korrespondieren und dieses Gehäuse 2 ebenfalls beim Einstecken führen. An der treppenförmig gestalteten Unterseite 23 des Elektronikmodulgehäuses 2 sind drei Reihen von Ausnehmungen 28 bzw. 29 zu erkennen, wobei zum einen Ausnehmungen 29 für die signalleiterseitigen Steckkontakte 11 passend zur Reihung der Anschlußscheiben 24-27 angeordnet sind, durch die die Steckkontakte 11, die in Form von erhabenen Einzelsockeln nach oben von den Anschlußscheiben 24-27 abstehen, in das Innere des Gehäuses des Elektronikmodules 2 hineinragen. In diese Steckkontakte 11 werden damit korrespondierende Vorsprünge an den nicht dargestellten Funktionsleiterplatten 40 eingesteckt und stellen damit eine elektrische Verbindung zwischen der Elektronik des Elektronikmodules 2 und dem Anschlußblock 3 her. Die Funktionsleiterplatten 40 werden in Führungsschienen 30 auf den beiden Kopfseiten des Gehäuses des Elektronikmodules 2 geführt, so daß eine einfache Einsteckbewegung zur genauen Positionierung dieser Funktionsleiterplatten 40 relativ zu den Steckplätzen der Steckverbinder 11 erzielbar ist.

Zwischen den beiden Reihen der Ausnehmungen 29 für die Steckanschlüsse 11 sind jeweils die Ausnehmungen 28 angeordnet, durch die die Rasthaken 17 von unten her in das Gehäuseinnere hindurchtreten, wobei in einigen der Ausnehmungen 28, vorzugsweise zwei bis drei Ausnehmungen, mit den Rasthaken 17 korrespondierende, nicht näher dargestellte Formelemente vorgesehen sind, so daß das Gehäuse in vertikaler Richtung durch ein Einrasten von Rasthaken 17 an den Formelementen der Ausnehmungen 28 in seiner Lage befestigt wird.

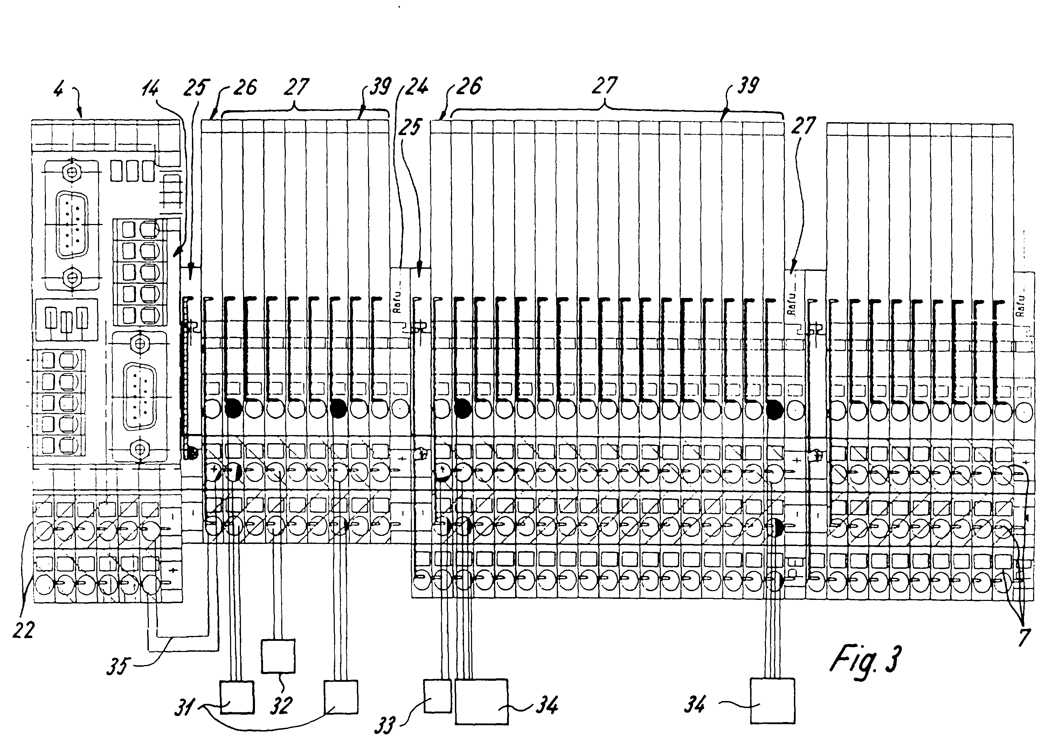

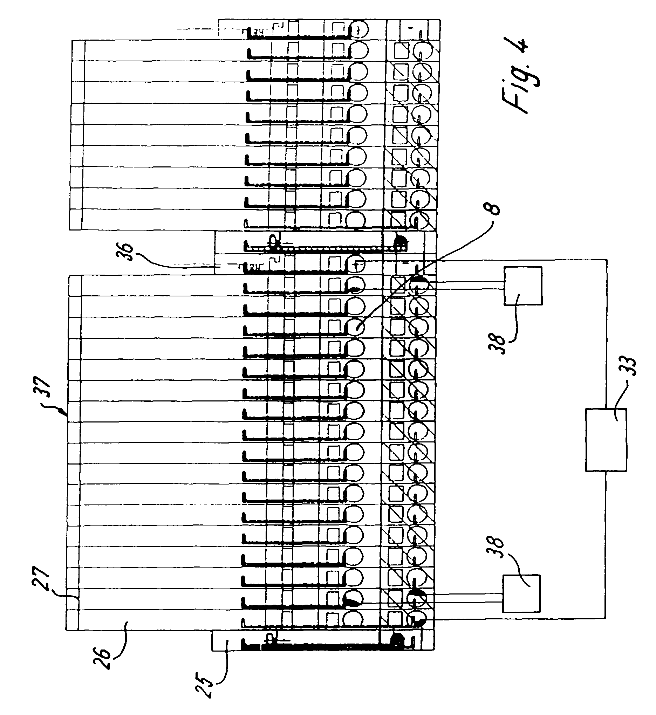

In den Figuren 3 und 4 sind typische Verschaltungsanordnungen eines Feldbus-Anschlußmodules 4 mit Anschlußblocks 3 zur Verbindung von Initiatoren, Aktoren, Feldgeräten oder dergleichen mit dem internen Busleiter 13 aufgezeigt. Der Feldbusanschlußmodul 4 enthält neben der hier nicht weiter erläuterten Anpaßelektronik einen Bereich die Anschlußelemente 22 zur elektrischen Versorgung des Feldbusanschlußmodules 4 sowie zur Verteilung elektrischer Potentiale an nachgeordnete Anschlußblocks 3. Der Feldbusanschlußmodul 4 sitzt ebenfalls rastbar auf der nicht dargestellten Tragschiene 1, wobei sich an den Feldbusanschlußmodul 4 direkt ein erster Anschlußblock 3 aus 11 Anschlußscheiben 24-27 und daran anschließend ein zweiter Anschlußblock 3 aus 19 Anschlußscheiben 24-27 anschließt. Jeder der beiden Anschlußblocks 3 besteht in erfindungsgemäßer Weise aus einer Reihung einer Schutzleiterscheibe 25, einer Einspeisescheibe 26, einer Anzahl von Versorgungs-/Signalleiterscheibe 27 sowie einer Rastfußscheibe 25, wobei die beiden Anschlußblocks 3 ebenfalls in direkter Reihung aneinander anschließen, so daß die Rastfußscheibe 24 des ersten Anschlußblockes 3 direkt an der Schutzleiterscheibe 25 des zweiten Anschlußblockes 3 anliegt. Die Verbindung zwischen den beiden Anschlußblocks 3 sowie weiteren, rechts nur angedeuteten Anschlußblocks 3 und dem Feldbusanschlußmodul 4 wird durch den internen Busleiter 13 hergestellt, wobei hier nur der Bereich eines Trennschiebers 14 angegeben wird, mit dem der Busleiter 13 des ersten Anschlußblockes 3 mit dem Busleiter 13 des Feldbusanschlußmodules 4 lösbar verbindbar ist.

Jeder der beiden Anschlußblocks 3 weist eine Anzahl von Verteilerleisten aus Anschlußelementen 7 auf, der erste Anschlußblock 3 zwei Verteilerleisten, der zweite Anschlußblock 3 drei Verteilerleisten, mit denen unterschiedliche elektrische Potentiale innerhalb eines Anschlußblockes 3 querverteilt werden. Die Spannungsversorgung des ersten Anschlußblockes 3 wird mittels einer Verkabelung 35 zur internen Spannungsversorgung von den Anschlußelementen 22 am Feldbusanschlußmodul 4 auf die Einspeisescheibe 26 des ersten Anschlußblocks 3 geführt und von dort mittels der Anschlußelemente 7 in je einer Reihe querverteilt, so daß an jeder der nachfolgenden Versorgungs-/Signalleiterscheiben 27 ein bestimmtes Potential mit einem Plus- und einem Minuspol zur Verfügung steht. Die Querverteilung endet vor der Rastfußscheibe 24, an die eine erneute Potentialversorgung der im zweiten Anschlußblock 3 angeordneten Einspeisescheibe 26 erfolgt. Im zweiten Anschlußblock wird das an der Schutzleiterscheibe 25 von der Tragschiene 1 abgegriffene elektrische Potential des Schutzleiters auf eine dritte Verteilerleiste herausgeführt und in dieser Verteilerleiste auf die anderen Anschlußscheiben 27 des zweiten Anschlußblockes 3 querverteilt. Somit stehen an dem zweiten Anschlußblock 3 neben dem Plus- und Minuspotential auch das Schutzleiterpotential für einen Anschluß hierzu vorgesehener Sensoren 34 zur Verfügung.

Beide Anschlußblocks 3 sind für den Anschluß von Initiatoren oder Feldgeräten vorgesehen, die digitale Signale zurückmelden, beziehungsweise als ein passiver Sensor 32 ausgeführt sind. Zum einen werden die Initiatoren 31 und 32 an die Versorgungs-/ Signalleiterscheiben 27 des ersten Anschlußblockes 3 mittels Zwei- oder Dreileitertechnik angeschlossen, zum anderen sind die Initiatoren 34 mittels Vierleitertechnik an die Versorgungs- und Signalleiterscheiben 27 des zweiten Anschlußblocks 3 angeschlossen. Die Sensoren 31 sind hierbei aktive Sensoren, die mit einer Gleichspannungsversorgung zu betreiben sind und über eine Signalleitung eine Rückmeldung an den Anschlußblock 3 liefern, der an der Signalleiterscheibe 27 aufgelegt ist. Hingegen ist der Sensor 32 ein passiver Sensor, dessen Signal aus einer Veränderung der Versorgungsspannung besteht, wobei ein Anschluß auf den Versorgungsbereich und der andere Anschluß direkt auf den Signalleiterbereich der Versorgungs-/Signalleiterscheibe 27 gelegt wird. Innerhalb des ersten Anschlußblockes 3 werden durch Kontaktierungsstege, die im weiteren noch erläutert werden, diese auf den Signalleiteranschlüssen anliegenden elektrischen Potentiale zu den Steckanschlüssen 11 zum Anschluß an den Elektronikmodul 2 geleitet, wo diese Signale dann be- und verarbeitet und auf den interen Busleiter 13 aufgeschaltet werden. Hingegen sind die Sensoren 34 als aktive Sensoren ausgeführt, die mit einer Gleichspannungsversorgung zu betreiben sind, wobei ein Schutzleiter, beispielsweise für Erdungszwecke, hinzukommt und eine Signalleitung von dem Sensor zurück auf die Signalleiterklemme geführt wird. Der zweite Anschlußblock 3 wird wiederum über eine eigene Spannungsversorgung 33 mit dem Gleichspannungspotential beaufschlagt.

In der Figur 4 sind zwei weitere Anschlußblocks 37 dargestellt, die beispielsweise in einer Reihung an die in der Figur 3 dargestellten Anschlußblocks 3 anschließen und auf einer gemeinsamen Tragschiene 1 sitzen können. Diese Anschlußblocks 3 bilden Ausgangsbaugruppen 37, die beispielsweise für die Versorgung von Aktoren 38 genutzt werden können. Der Aufbau des Anschlußblockes 37 ist analog aus einer Schutzleiterscheibe 25, einer Einspeisescheibe 26, einer Anzahl von Versorgungs-/Signalleiterscheiben und einer Rastfußscheibe 36 gebildet. Der Anschlußblock 37 beinhaltet eine Verteilerleiste aus Anschlußelementen 7, die ein negatives Potential, das von einer externen Spannungsversorgung 33 aufgeschaltet wird, zum einen auf die Verteilerleiste legt und zum anderen als Gegenpol die Ausgangsbaugruppe 32 über die Ratsfußscheibe versorgt. An zwei Anschlußscheiben 27 sind je 1 Aktor 38 angeschlossen, der das negative Potential von dem Versorgungsanschluß abgreift und dessen Signalleitung an den zugehörigen Signalleiteranschluß 8 aufgelegt ist. Die Rastfußscheibe 24 des Anschlußblockes 37 weist als Besonderheit auf, daß das positive Potential, das über die Augangselektronik auf die Signalleiteranschlüsse 8 aufgelegt ist, im Notfall über einen nicht dargestellten, externen Schalter abgetrennt werden kann, ohne daß die Ausgänge zurückgesetzt werden müßten.

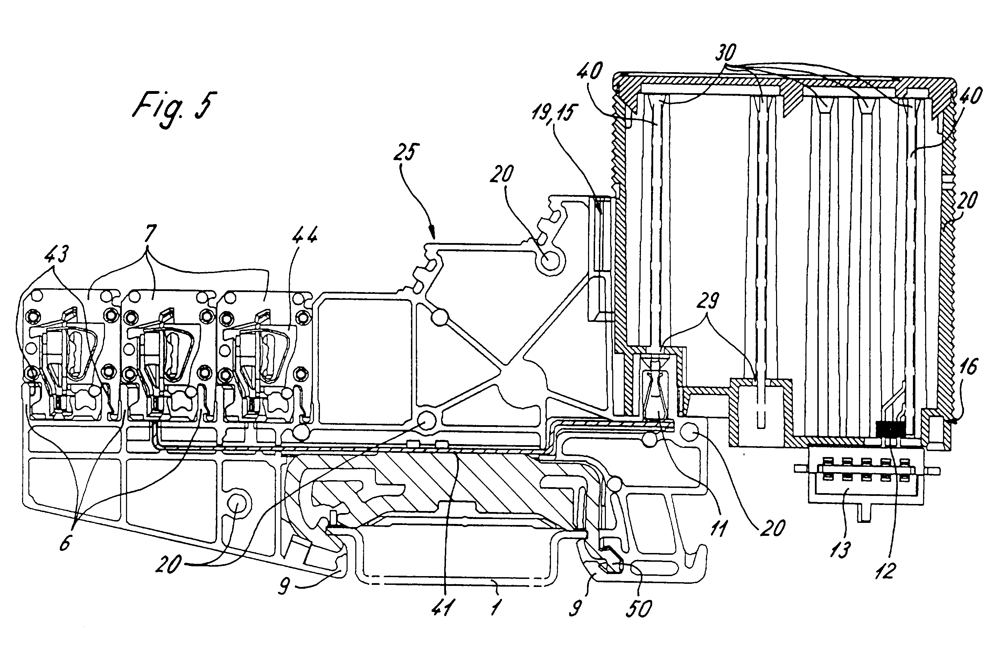

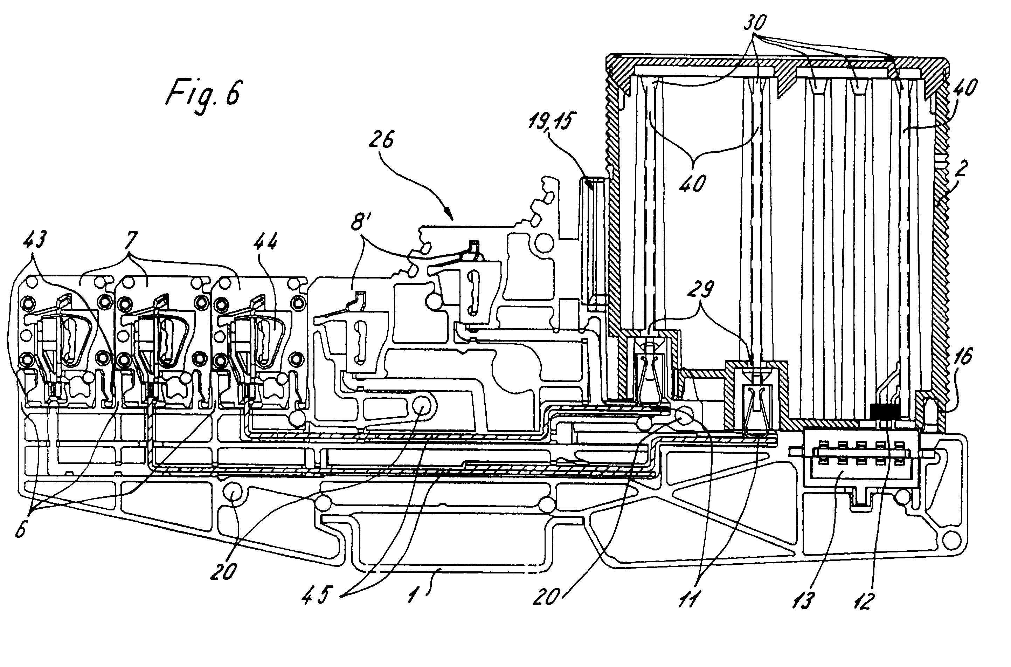

In den Figuren 5 bis 11 werden einige Beispiele des Aufbaus von Anschlußscheiben mit unterschiedlichen Funktionen dargestellt, wobei zur Beschreibung funktionsgleichen Bauelemente gleiche Sachnummern verwendet werden, so daß für die Figur 5 ausführlich der Aufbau einer Anschlußscheibe, hier einer Schutzleiterscheibe 25 mit Erläuterung aller verwendeten Sachnummern vorgenommen wird und im weiteren für die Beschreibung der Figuren 6 bis 11 nur auf die Besonderheiten der jeweiligen Anschlußscheibe hinsichtlich ihrer Funktion und ihres Aufbaus verwiesen wird.

In der Figur 5 ist eine Schutzleiterscheibe 25 in einer Seitenansicht in Richtung der Tragschiene 1 mit aufgestecktem Elektronikmodul 2 sowie daran angeordnetem Busleiterbereich 13 dargestellt. Die Schutzleiterscheibe 25 ist auf der Tragschiene 1 mittels der Rastfüße 9 aufgerastet, wobei über das Abgreifblech 50 eine Verbindung zu einem Kontaktierungssteg 41 hergestellt wird, der mit dem Steckanschluß 11 für den Anschluß des Signalleiters an den Elektronikmodul 2 und einem in die mittlere von drei Vorrichtungen zur Aufnahme von Verteilerleisten eingesteckten Anschlußelement 7 hergestellt wird.

Weiterhin erkennt man die Anreihzapfen bzw. -bohrungen 20, mit denen die Schutzleiterscheibe 25 mit benachbarten Anschlußscheiben eines Anschlußblockes mechanisch gekoppelt wird. Im Bereich der Verteilung sind die drei Vorrichtungen zur Aufnahme von Verteilerleisten 6 mit jeweils zur Verteilerleiste anreihbarem Anschlußelement 7 bestückt, wobei jedes Anschlußelement 7 mittels Verrastungselementen 43 in die Vorrichtung zur Aufnahme von Verteilerleisten eingesteckt und befestigt ist. Innerhalb jedes Anschlußelementes 7 sind hier als Kabelklemmvorrichtungen 44 ausgeführte Befestigungsmöglichkeiten für in vertikaler Richtung einsteckbare Versorgungskabel vorgesehen. Die Signalleiterklemmen 8 sind in der Schutzleiterscheibe 25 nicht vorgesehen und daher ist das Gehäuse der Anschlußscheibe hier nicht weiter bestückt. An den Signalleiterbereich schließt sich die Führungsfläche 15 mit darin eingearbeiteten T-Nuten an, an denen das Gehäuse des Elektronikmodules 2 anliegt und vertikal mit den entsprechenden T-Nuten-Gegenstücken 19 geführt und über die hier nicht dargestellten Rasthaken 17 verrastbar sind. Innerhalb des Gehäuses des Elektronikmodules 2 sitzen in der schon beschriebenen Weise die Funktionsleiterplatten 40, die in den Führungsschienen 30 geführt und an ihrer Unterseite mit zu den Steckanschlüssen 11 korrespondierenden Vorsprüngen in die Steckanschlüsse 11 einsteckbar sind. An der Schutzleiterscheibe 25 ist lediglich ein Steckanschluß 11 ausgeführt, der einen Schutzleiteranschluß des Elektronikmodules 2 an die Tragschiene 1 ermöglicht. Man erkennt weiterhin die Ausnehmungen 29, durch die die mit den Steckanschlüssen 11 korrespondierenden Elemente der Funktionsleiterplatten 40 in diese Steckanschlüsse 11 eingesteckt werden. Ebenfalls erkennbar ist der Steckverbinder 12, mit dem eine Funktionsleiterplatte 40 mit dem internen Busleiter 13 verbunden ist. Die Schutzleiterscheibe 25 hat als Funktion zum einen die Bereitstellung einer mechanischen Verrastung eines Anschlußblockes mit der Tragschiene 1, zum anderen das Abgreifen des über die Tragschiene 1 anliegenden Schutzleiters und Weiterleitung dieses Schutzleiterpotentials zum einen auf den Steckanschluß 11 für den Elektronikmodul 2 und zum anderen auf das Anschlußelement 7, das über den Kontaktierungssteg 41, der an dem Abgreifblech 50 anliegt, wiederum mit der Tragschiene 1 mechanischen Kontakt hat.

In der Figur 6 ist eine Einspeisescheibe 26 entsprechend dem in der Figur 5 dargestellten grundsätzlichen Aufbau gezeigt, wobei hier die Rastfußfunktion der Schutzleiterscheibe 25 nicht realisiert ist und auch kein elektrischer Kontakt mit der Tragschiene 1 besteht. Es ist lediglich eine mechanische Anlagefunktion über entsprechende Formelemente im unteren Bereich des Gehäuses der Einspeisescheibe 26 mit der Tragschiene 1 realisiert. Die Einspeisescheibe 26 dient dazu, den Elektronikmodul 2 und die aus Anschlußelementen 7 gereihten Verteilerleisten mit mindestens einem Spannungspotential zu versorgen, wozu die von oben in die Anschlußelemente 7 eingesteckten Kabelverbinder zur Spannungsversorgung über Kontaktierungsbleche 45 jeweils mit den Steckanschlüssen 11 für den Elektronikmodul 2 verbunden sind. Gleichzeitig wird über die Anschlußelemente 7 die Versorgungsspannung an die benachbarten Versorgungs-/Signalleiterscheiben 27 querverteilt. Auch ist hier wiederum der Signalleiterbereich nicht vorgesehen, zumindestens aber nicht elektrisch bestückt.

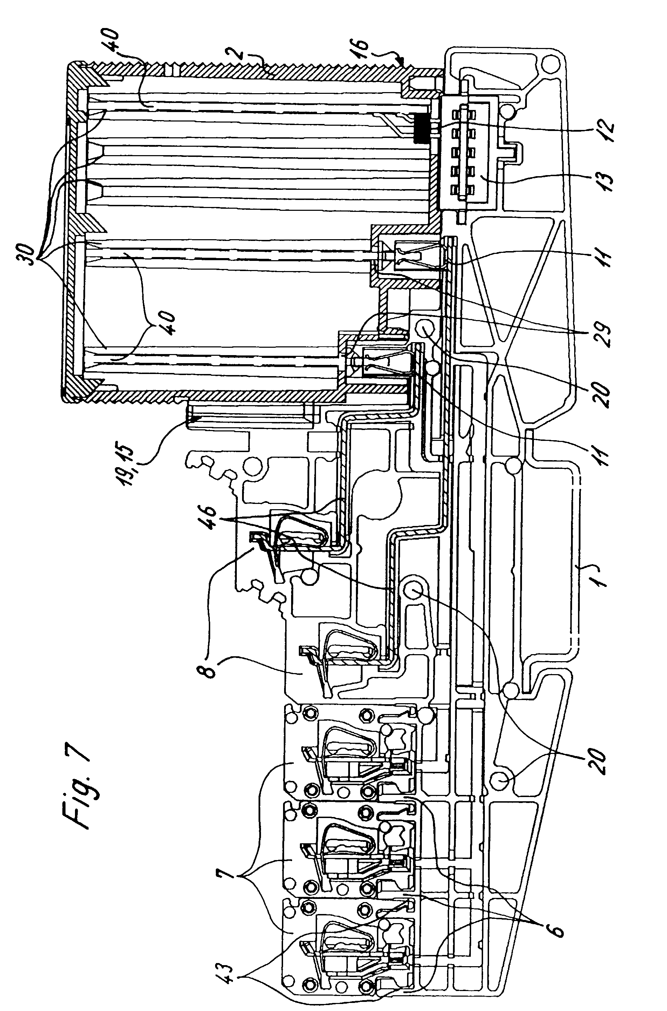

In der Figur 7 ist eine Versorgungs-/Signalleiterscheibe 27 entsprechend dem prinzipiellen Aufbau der Figuren 5 bzw. 6 dargestellt, wobei wiederum lediglich eine mechanische Anschlagfunktion im Anschlußbereich zur Tragschiene 1 der Versorgungs-/ Signalleiterscheibe 27 vorgesehen ist und die Versorgungs-/ Signalleiterscheibe 27 über die Anreihbolzen 20 mit den benachbarten Scheiben verbindbar ist. Aufgabe der Versorgungs-/ Signalleiterscheibe 27 ist es, zum einen über die Querverteilung mittels der Anschlußelemente 7 von einer Einspeisescheibe 26 bereitgestellte elektrische Potentiale für den Anschluß von Initiatoren, Aktoren, Feldgeräten oder dergleichen bereitzustellen und zum anderen die von bzw. zu diesen Initiatoren, Aktoren, Feldgeräten o. dgl. zurückkommenden bzw. abgehenden Signale auf die Signalleiterklemmen 8 aufzulegen. Diese Signalleiterklemmen 8 sind mittels Kontaktierungsstegen 46 mit dem Elektronikmodul 2, hier den beiden Steckanschlüssen 11 für den Anschluß des Elektronikmoduls verbunden. Die dargestellte Versorgungs-/ Signalleiterscheibe 27 erlaubt z.B. den Anschluß eines Initiators und eines Aktors mit jeweils einer Signalleitung, wobei für die Versorgung beispielsweise ein Pluspotential für den Initiator und ein Minus- bzw. ein Pluspotential für den Aktor von den Anschlußelementen 7 abgreifbar ist.

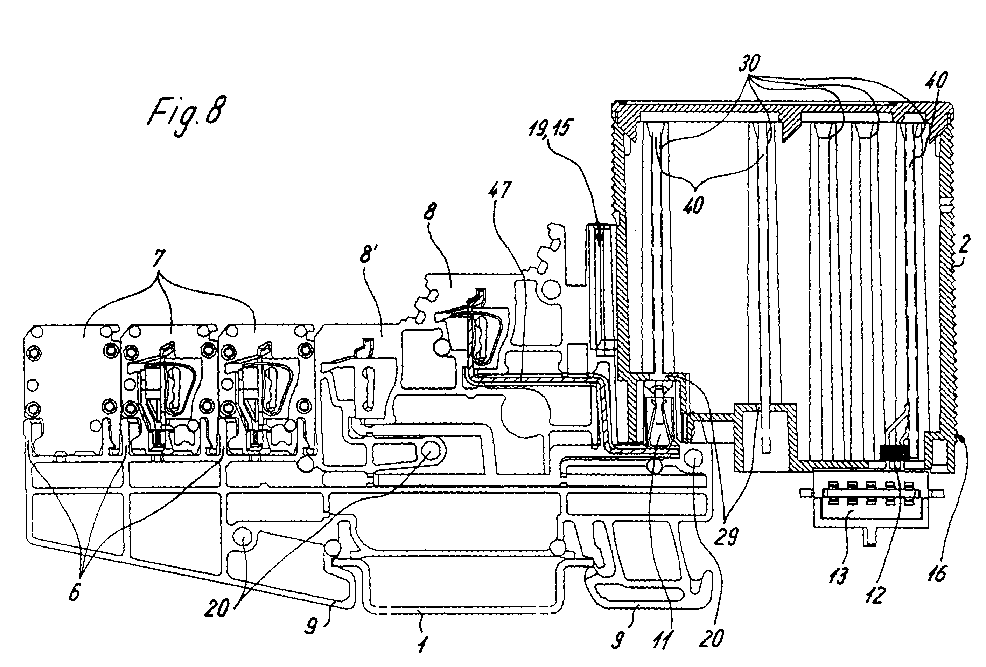

In der Figur 8 ist eine Rastfußscheibe 24 dargestellt, die in entsprechender Weise zur Schutzleiterscheibe der Figur 5 mit der Tragschiene 1 verrastbar ausgeführt ist, wobei aber der elektrische Anschluß an die Tragschiene 1 entfällt. Neben den nur teilweise bestückten Anschlußelementen 7 in den Vorrichtungen 6 zur Aufnahme von Verteilerleisten ist eine Signalleiterklemme 8 bestückt und mittels eines Kontaktierungssteges 47 mit dem Steckanschluß 11 für den Elektronikmodul 2 verbunden, worüber beispielsweise eine Einspeisung eines elektrischen Potentials separat für den Elektronikmodul 2 realisierbar ist. Der andere Signalleiteranschluß 8' ist gehäuseseitig ausgebildet, aber nicht durch elektrische Kontaktierungsstege 47 bestückt.

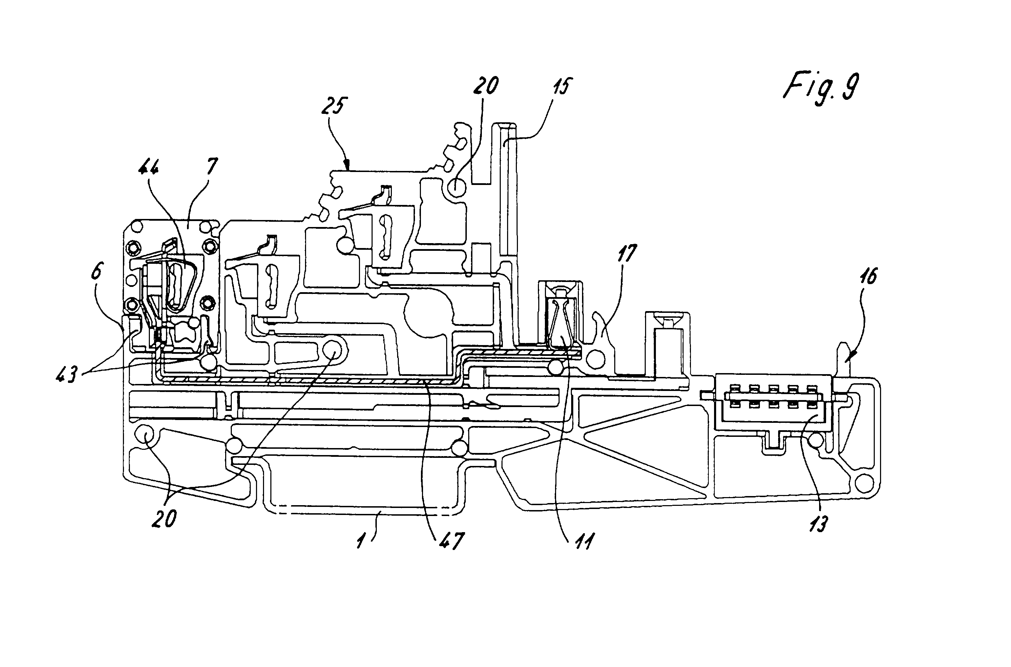

In der Figur 9 ist eine Einspeisescheibe 26 dargestellt, die mit nur einer Vorrichtung 6 zur Aufnahme von einer Verteilerleiste und darin steckbar befestigten Anschlußelement 7 ausgerüstet ist, von dem mittels eines Kontaktierungssteges 47 der Steckanschluß 11 für den hier nicht dargestellten Elektronikmodul 2 verbunden ist. Dies ist eine andere Ausführungsform für eine Einspeisescheibe 26, bei der nur ein Leiter der Versorgungsanschlüsse direkt mit dem Elektronikmodul 2 verbunden ist.

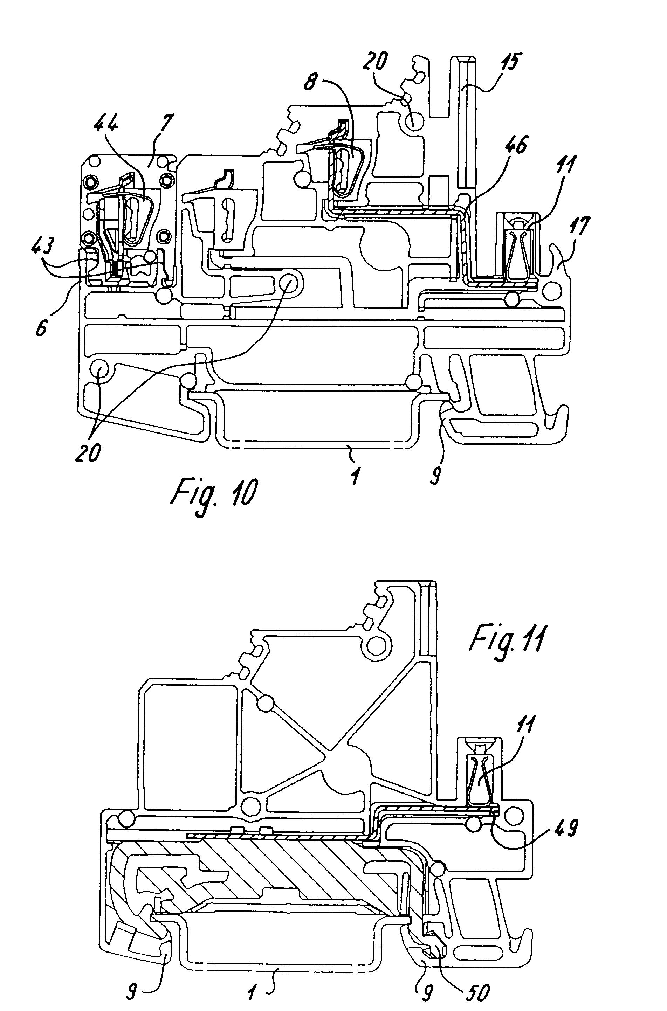

In der Figur 10 ist eine Rastfußscheibe 24 dargestellt, die mittels eines Rastfußes 9 an der Tragschiene 1 klemmend befestigbar ist und bei der nur eine Vorrichtung 6 zur Aufnahme von Verteilerleiste ausgebildet ist. In diese Vorrichtungen 6 ist ein Anschlußelement 7 eingesteckt. Weiterhin ist der Signalleiteranschluß 8 verbunden mit dem Steckanschluß 11 für den Elektronikmodul 2, wobei diese beiden Kontakte mittels eines Kontaktierungssteges 46 elektrisch verbunden sind. Hierdurch ist es möglich, eine separate Einspeisung eines elektrischen Potentials ausschließlich für den Elektronikmodul 2 vorzusehen, wie dies für die Betriebssicherheit von an digitalen Ausgabeeinheiten angeschlossenen Aktoren notwendig ist.

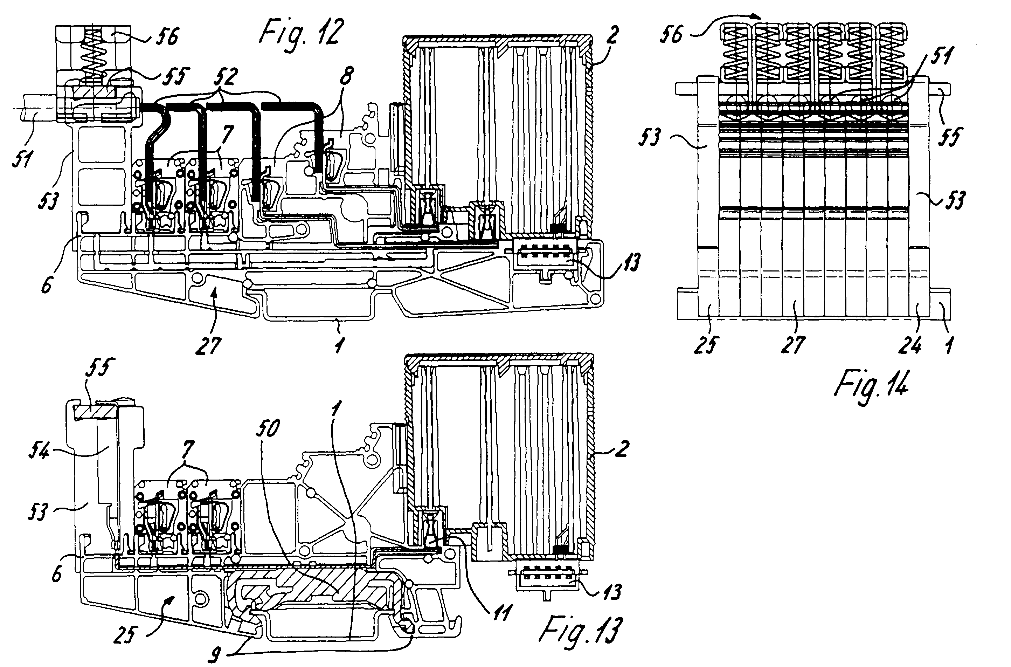

In der Figur 11 ist eine Rastfußscheibe 24 dargestellt, die keine Vorrichtung 6 zur Aufnahme von Verteilerleisten und auch keinen Busleiterbereich 13 aufweist und die lediglich einen eigenen Schutzleiteranschluß für den nicht dargestellten Elektronikmodul 2 aufweist. Hierzu wird von der Tragschiene 1 mittels eines Abgreifbleches 50, das an den Rastfüßen 9 angeordnet ist, das Schutzleiterpotential über einen Kontaktierungssteg 49 auf den Steckanschluß 11 für den Elektronikmodul 2 geleitet.

In den Figuren 12 bis 14 ist für einen Anschlußblock dargestellt, wie die Schirmung versorgungsseitig angeschlossener Verbindungen zu Initiatoren, Aktoren, Feldgeräten elektrisch und mechanisch realisiert ist. Hierzu wird auf die beiden den Anschlußblock begrenzenden Scheiben, üblicherweise die Schutzleiterscheibe und die Rastfußscheibe 24 ein Bügel aufgesetzt, der aus zwei den Anschlußscheiben 24, 25 zugeordneten Stecksockeln 53 besteht, zwischen denen eine Sammelschiene 55, die elektrisch leitend ist, angeordnet wird. Diese Anordnung wird an der Stelle der Schutzleiterverteilerleiste auf dem Anschlußmodul aufgerastet. Diese Sammelschiene 55 ist mittels eines in der Figur 13 dargestellten Kontaktierungsbleches 54 in der Schutzleiterscheibe 25 elektrisch leitend mit der Tragschiene 1 bzw. auch dem Elektronikmodul 2 verbindbar und stellt somit oberhalb des Anschlußbereiches der Versorgungs- und Signalleiter einen direkten Abgriff der Schirmung der einlaufenden Kabel dar. Hierzu wird der abisolierte und hinsichtlich der Schirmung einzeln vorliegende Kabelstrang 51 elektrisch und mechanisch so an der Sammelschiene 55 befestigt, daß über einen federnd aufsteckbaren und mit der Sammelschiene 55 verrastbaren Kabelkabelklemmschuh 56 z.B. unterseitig der Sammelschiene 55 das Kabel 51 an die Sammelschiene angepreßt wird, wozu oberseitig der Sammelschiene ein federndes Element angeordnet ist, das die Anpreßwangen des Kabelschuhes gegen die Sammelschiene 55 zieht. Es ist also zum Anschluß der Schirmung eines mehradrigen Kabels 51 nur erforderlich, die Einzeladern 52 in entsprechender Länge bezüglich Schirmung und Kabelisolierung so abzuisolieren, daß die Schirmung z.B. unterhalb der Sammelschiene 55 zu liegen kommt und die Einzeladern 52 an die jeweiligen Anschlußstellen der Anschlußscheiben 27 geführt werden können. Somit steht über die Sammelschiene 55 direkt an der Stelle, an der das Kabel 51 auf den Anschlußblock aufliegt, eine Anschlußmöglichkeit für die Schirmung zur Verfügung, wodurch sich umständliche Weiterverbindungen der Schirmung des Kabels 51 in den eigentlichen Anschlußbereich erübrigen.

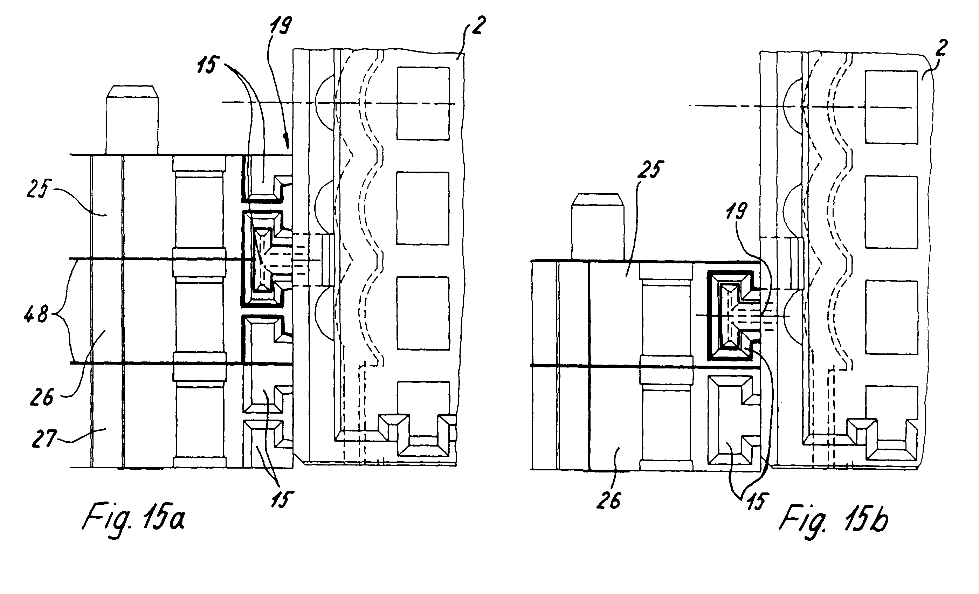

In der Figur 15 ist in einer Ansicht von oben dargestellt, wie das Gehäuse des Elektronikmodules 2 mittels der T-Nuten-Gegenstücke 19 in die von bzw. in den Anschlußscheiben 25-27 gebildeten T-Nuten der Führungsfläche 15 eingreifen. Die T-Nuten in der Führungsfläche 15 werden dabei z.B. so gebildet, daß in jeder der Anschlußscheiben 25-27 auf den beiden Stirnseiten im Bereich der Führungsfläche 19 halbe T-Nuten eingearbeitet sind, die nach dem Aneinanderreihen der einzelnen Anschlußscheiben 25-27 mit dem jeweiligen Gegenstück der jeweils benachbarten Anschlußscheibe 25-27 eine komplette T-Nut bilden. In diese beidseitig gebildeten T-Nuten wird dann das T-Nuten-Gegenstück 19, das gehäuseseitig am Elektronikmodul 2 befestigt ist, vertikal eingeschoben.

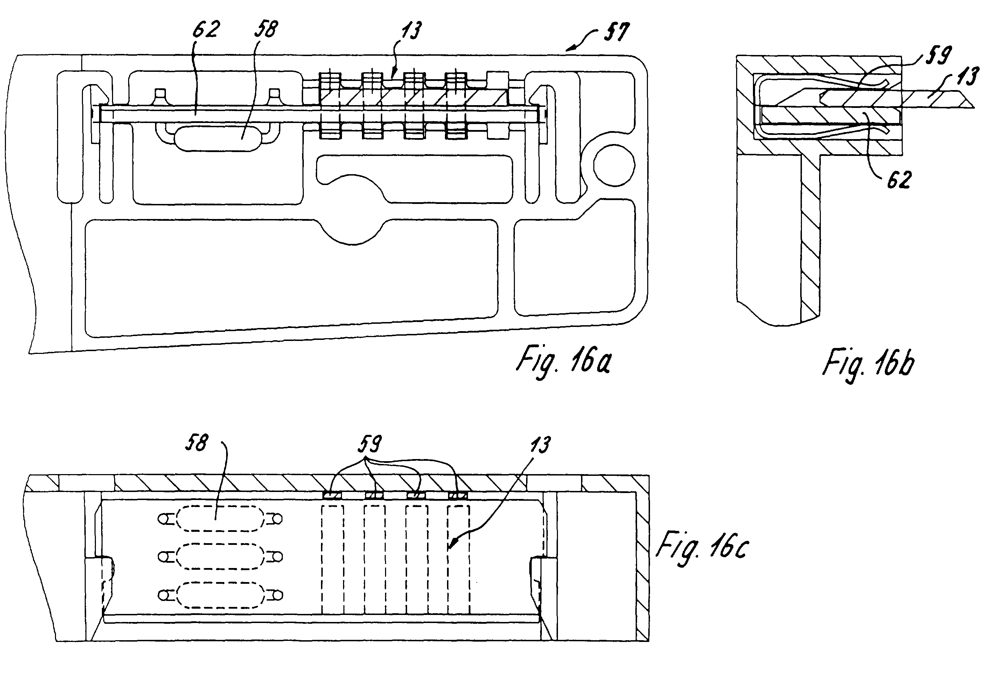

In den Figuren 16a - 16c ist aufgezeigt, wie eine Abschlußscheibe 57 am Ende des Busleiterbereichs 13 steckbar auf der Busleiterplatine angeordnet ist, um eine Signalreflexion am Ende des Busleiters 13 zu verhindern. Hierzu wird eine kleine separate Platine 62 innerhalb der im wesentlichen aus einem Stecksockel gebildeten Abschlußscheibe 57 so angeordnet, daß sie beim Aufstecken auf die Busleiterplatine 13 unterhalb dieser zu liegen kommt und mittels auf die Abschlußscheibe 57 aufsteckbaren Verbindungsfedern 59 mit den Leiterbahnen auf der Busleiterplatine 13 verbindbar ist. Unterhalb der separaten Platine 62 sitzen die Abschlußwiderstände 58, die zwischen die Einzelleiter des Busleiters 13 geschaltet werden, um unerwünschte Signalreflexionen am Ende des Busleiters 13 zu verhindern.

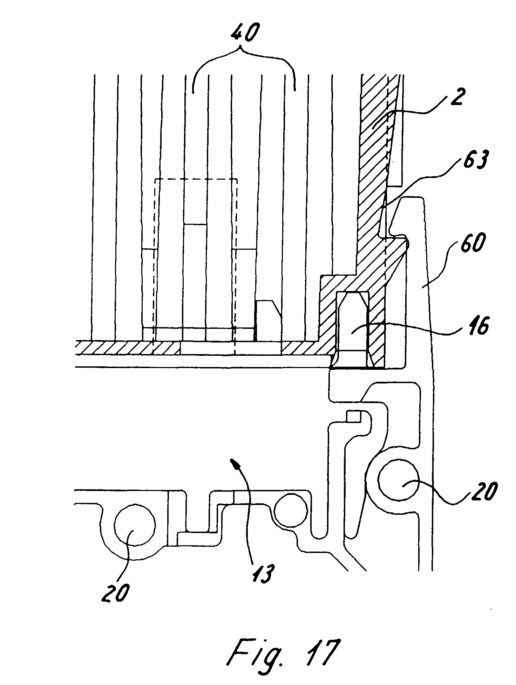

In der Figur 17 ist eine zusätzliche Möglichkeit der Sicherung des Gehäuses des Elektronikmoduls 2 gegen Abnehmen vom Anschlußblock 3 dargestellt. Auf der dem Versorgungsbereich abgewandten Seite jeder Anschlußscheibe 24 - 27 ist passend zum zugeordneten Gehäusebereich je ein Rasthaken 60 vorgesehen, der mit einer dazu passenden Rastvertiefung 63 des Gehäuses des Elektronikmoduls 2 zusammenwirken kann. Es soll allerdings je Anschlußblock vorzugsweise nur je ein Rasthaken 60 in eine zugeordnete Rastvertiefung 63 eingreifen, da diese Rastverbindung nur zur Sicherung des Gehäuses des Elektronikmoduls 2 gegen unbeabsichtigtes Abziehen bzw. Abziehen von Anschlußblock 3 in nicht spannungsfrei geschalteten Zustand dienen soll. Zum Abziehen des Gehäuses des Elektronikmoduls 2 ist somit ein Werkzeug erforderlich, mit dem der Rasthaken 60 freigegeben werden muß, bevor der Elektronikmodul 2 abziehbar ist.

In der Figur 18 ist eine weitere Möglichkeit dargestellt, wie innerhalb einer durch Reihung von Anschlußelementen 7 gebildeten Verteilerleiste auch unterschiedliche elektrische Potentiale aufgelegt werden können. Hierzu wird zwischen die Bereiche gleichen elektrischen Potentials, die durch die querverbindenden Anschlußelemente 7 gebildet werden, an den Übergangsstellen mindestens je ein nicht querverbindendes Trennelement 61 eingesteckt, das von den mechanischen Anschlußmaßen den Anschlußelementen 7 entspricht, elektrisch jedoch nicht bestückt ist. Hierdurch wird die Querverbindung der gereihten Anschlußelemente 7 unterbrochen und es kann an dem darauffolgenden Anschlußelement 7 der Reihung beispielsweise über eine externe Spanungsversorgung 33 oder eine interne Verbindung zur Einspeisescheibe 26 ein anderes elektrisches Potential aufgelegt werden. Hierdurch ist es im besonderen möglich, bei nicht für gleichartige Initiatoren/Aktoren/Feldgeräte oder dgl. aufgebaute Anschlußblöcke 3 eine einfache Versorgung mit unterschiedlichen elektrischen Potentialen zu ermöglichen. Es ist weiterhin möglich, dies nicht querverbindenden Trennelemente 61 dazu zu nutzen, die angelegten elektrischen Potentiale z.B. in Form einer Beschriftung kenntlich zu machen. Es ist ebenfalls denkbar, die schon angeführte Möglichkeit zum Einstecken eines Brückenelementes 21 zur elektrischen Verbindung zweier Verteilerleisten mit der vorstehend genannten Möglichkeit der scheibenweise unterschiedlichen elektrischen Potential zu kombinieren.

### Bezugszeichenliste

- 1: Tragschiene
- 2: Elektronikmodul bzw. Gehäuse des Elektronikmodules
- 3: Anschlußblock
- 4: Gatewayscheibe
- 5: Anschlußscheiben
- 6: Vorrichtungen zur Aufnahme von Verteilerleisten
- 7: Anschlußelemente, reihbar zur Verteilerleiste
- 8: Signalleiteranschlüsse
- 9: Rastfüße
- 10: Verbindungselemente Kabel
- 11: Steckanschlüsse f. Signalleiter an Elektronikmodul
- 12: Steckverbinder interner Busleiter an Elektronikmodul
- 13: Busleiter
- 14: Trennschieber
- 15: Führungsfläche mit T-Nuten
- 16: Führungslaschen
- 17: Rasthaken
- 18: Justierungsprofil
- 19: Verrastungselemente
- 20: Anreihbolzen bzw. -bohrung
- 21: Führungsleisten f. Steckanschlüsse d. Signalleiter
- 22: Gegenstück zu Steckverbinder 11
- 23: Zentrale Funktionsleiterplatte
- 24: Rastfußscheibe
- 25: Schutzleiterscheibe
- 26: Einspeisescheibe
- 27: Versorgungs-/Signalleiterscheibe
- 28.: Verbindungsstege Funktionsleiterplatten
- 30: Führungsschienen für Funktionsleiterplatten
- 31: Sensor, aktiv mit Gleichspannungsversorgung und einer Signalleitung
- 32: Sensor, passiv
- 33: Externe Spannungsversorgung
- 34: Sensor, aktiv mit Schutzleiter und einer Signalleitung
- 25: Sensor mit 4-Leiter-Anschluß
- 36: Trennstecker
- 37: Querverteilerkamm
- 38: Aktor mit einer Signalleitung
- 40: Funktionsleiterplatte
- 41: Kontaktierungssteg Schutzleiter/Elektronikmodul/ Verteilerleiste
- 45: Kontaktierungssteg/Einspeisung/Elektronikmodul
- 46: Kontaktierungssteg/Signalleiter/Elektronikmodul
- 50: Abgreifblech
- 57: Abschlußscheibe
- 58: Abschlußwiderstand
- 59: Verbindungsfeder
- 60: Rasthaken
- 61: Nicht-querverbindendes Einsteckelement
- 62: Trägerplatine
- 63: Rastvertiefung

## Patentansprüche

1. Modulare Steuerungsanlage für elektronische Steuerungs- und Automatisierungssysteme bestehend aus
- mindestens zwei auf eine gemeinsame Tragschiene (1) klemmbarer und anreihbaren Anschlußblöcken (3) aus je einer Anzahl anreihbarer Anschlußscheiben (24, 25, 26, 27) und darin angeordneten Versorgungsanschlüssen und/oder Signalleiteranschlüssen für zugeordnete Initiatoren, Aktoren, Feldgeräte oder dgl.,
- Einrichtungen zur Verteilung elektrischer Potentiale innerhalb desselben Anschlußblocks (3),
- einem internen Busleiter (13) zur Verbindung aller auf der Tragschiene (1) angeordneter Anschlußblöcke (3),
- mindestens einem Elektronikmodul (2) zur Signalbe- und -verarbeitung bei der Verbindung von an die Signalleiter anschließbaren Initiatoren, Aktoren, Feldgeräten oder dgl. mit dem internen Busleiter (13),
- ein Anschlußmodul (4) für den Anschluß des internen Busleiters (13) an einen zugeordneten Feldbus,
**dadurch gekennzeichnet, daß**
- innerhalb jedes Anschlußblocks (3) mindestens eine Schutzleiterscheibe (25), mindestens eine Einspeisescheibe (26) und mindestens eine Versorgungs-/Signalleiterscheibe (27) angeordnet sind, deren vorgegebene Funktionsbereiche einen strukturierten Aufbau in fester räumlicher Aufeinanderfolge aufweisen,
- die Schutzleiterscheibe (25) Bereiche zum Abgriff eines Schutzleiterpotentials von der Tragschiene (1) und zum Weiterleiten des Schutzleiterpotentials auf das Elektronik-Modul (2) aufweist,
- die Einspeisescheibe (26) Bereiche zur Versorgung des Elektronikmoduls (2) und zur Versorgung von aus Anschlußelementen (7) gereihten Verteilerleisten mit mindestens einem Spannungspotential aufweist, und
- die Versorgungs-/Signalleiterscheibe (27) Bereiche zur Querverteilung elektrischer Potentiale an weitere Anschlußscheiben desselben Anschußblocks, an welche zugeordnete Initiatoren, Aktoren, Feldgeräte o.dgl. anschließbar sind sowie Bereiche zum Signalleiteranschluß der zugeordneten Initiatoren, Aktoren, Feldgeräte o.dgl. aufweist, wobei die räumliche Anordnung der Anschlußscheiben (24, 25, 26 ,27) in allen Anschlußblöcken in derselben Reihenfolge erfolgt.

2. Modulare Steuerungsanlage nach Anspruch 1, dadurch gekennzeichnet, daß wenigstens eine der Anschlußscheiben (24-27) ferner aufweist:
- einen Bereich zur lösbaren Anordnung des Elektronikmoduls (2), und/oder
- einen Bereich zur Anordnung des internen Busleiters (13).

3. Modulare Steuerungsanlage nach Anspruch 1 oder 2, **dadurch gekennzeichnet, daß** innerhalb jedes Anschlußblocks (3) die Anschlußscheiben (24-27) in der Reihenfolge: eine Schutzleiterscheibe (25), mindestens eine Einspeisescheibe (26), an die Einspeisescheibe anschließend mindestens eine Versorgungs-/ Signalleiterscheibe (27) und ggf. eine Rastfußscheibe (24) angeordnet sind.

4. Modulare Steuerungsanlage nach einem der Ansprüche 1, 2 oder 3, **dadurch gekennzeichnet, daß** die Schutzleiterscheibe (25) eine mechanische Befestigung auf und einen elektrischen Anschluß zur Tragschiene (1), einen Steckanschluß (11) zum Elektronikmodul (2) aufweist und daß der Bereich für den internen Busleiter (13) frei ist.

5. Modulare Steuerungsanlage nach einem der Ansprüche 1, 2 oder 4, **dadurch gekennzeichnet, daß** die Schutzleiterscheibe (25) mit der Potentialverteilung an weitere Anschlußscheiben (24, 26, 27) desselben Anschlußblocks (3) verbindbar ist.

6. Modulare Steuerungsanlage nach Anspruch 1 oder 2, **dadurch gekennzeichnet, daß** die Einspeisescheibe (26) einen Busleiterbereich (13) aufweist und mit der Potentialverteilung an weitere Anschlußscheiben (24-27) desselben Anschlußblocks (3) und dem Elektronikmodul (2) verbindbar ist.

7. Modulare Steuerungsanlage nach einem der Ansprüche 1, 2 oder 6, **dadurch gekennzeichnet, daß** die Einspeisescheibe (26) mit nur einer Versorgungs-/Signalleiterscheibe (27) innerhalb des Anschlußblocks (3) elektrisch leitend verbunden ist.

8. Modulare Steuerungsanlage nach einem der Ansprüchel 1, 5 oder 6, **dadurch gekennzeichnet, daß** an der Einspeisescheibe (26) nur eine Verbindung zum Elektronikmodul (2) besteht.

9. Modulare Steuerungsanlage nach Anspruch 1, **dadurch gekennzeichnet, daß** die Versorgungs-/Signalleiterscheibe (27) aus Vorrichtungen (6) zur Aufnahme von Verteilerleisten, mindestens einer Signalleiterklemme (8), den Steckanschlüssen für den Elektronikmodul (11) und dem Bereich für den internen Busleiter (13) besteht.

10. Modulare Steuerungsanlage nach einem der Ansprüche 1, 2 oder 9, **dadurch gekennzeichnet, daß** jede Vorrichtung (6) zur Aufnahme von Verteilerleisten Befestigungskonturen für die in die Verteilerleisten einsteckbaren und rastbaren, vorzugsweise farbig gestaltbaren, auch querverteilenden Anschlußelemente (7) aufweist.

11. Modulare Steuerungsanlage nach einem der vorstehenden Ansprüche, **dadurch gekennzeichnet, daß** jeder Anschlußblock (3) an beiden Durchtrittsseiten der Tragschiene (1) Anschlußscheiben (24, 25) aufweist, die jeweils der Tragschiene (1) zugeordnete Rastfüße (9) zur mechanischen Befestigung auf der und/oder elektrischen Verbindung mit dieser Tragschiene (1) aufweisen.

12. Modulare Steuerungsanlage nach einem der Ansprüche 1, 2 oder 11, **dadurch gekennzeichnet, daß** die Rastfußscheibe (24) ausschließlich eine mechanische Befestigung auf der Tragschiene (1) aufweist.

13. Modulare Steuerungsanlage nach einem der Ansprüche 1, 2, 11 oder 12, **dadurch gekennzeichnet, daß** die Rastfußscheibe (24) zum ausschließlichen Anschluß eines separaten Schutzleiters an den Elektronikmodul (2) als Schutzleiterscheibe (25) ausbildbar ist.

14. Modulare Steuerungsanlage nach einem der Ansprüch 1, ,2 oder 11 bis 13, **dadurch gekennzeichnet, daß** die Rastfußscheibe (24) als zweite Einspeisescheibe (26) zum ausschließlichen Anschluß eines Digital-Ausgabe-Moduls (37) und/oder des Elektronikmoduls (2) ausbildbar ist.

15. Modulare Steuerungsanlage nach einem der vorstehenden Ansprüche, **dadurch gekennzeichnet, daß** bei Verwendung von zwei Schutzleiterscheiben (25) innerhalb eines Anschlußblocks (3) diese in der Reihung am Anfang und am Ende des Anschlußblocks (3) angeordnet sind.

16. Modulare Steuerungsanlage nach einem der vorstehenden Ansprüche, **dadurch gekennzeichnet, daß** die Anschlüsse gleichartiger Initiatoren, Aktoren, Feldgeräte oder dgl. nach Bedarf in Anschlußblocks (3) gleichartiger Anschlußscheiben (27) zusammenfaßbar sind.

17. Modulare Steuerungsanlage nach einem der vorstehenden Ansprüche, **dadurch gekennzeichnet, daß** die Anschlüsse unterschiedlicher Initiatoren, Aktoren, Feldgeräte oder dgl. nach Bedarf in Anschlußblocks (3) unterschiedlicher Anschlußscheiben (27) zusammenfaßbar sind.

18. Modulare Steuerungsanlage nach Anspruch 1 oder 2, **dadurch gekennzeichnet, daß** der interne Busleiter (13) aus Busschienenstücken besteht, die über verschiebbare und rastbare Trennschieber (14) lösbar und elektrisch/mechanisch mit den benachbarten Busleiterstücken verbindbar sind.

19. Modulare Steuerungsanlage nach einem der vorstehenden Ansprüche, **dadurch gekennzeichnet, daß** die im Busleiterbereich (13) frei belassenen, in benachbarten Anschlußblocks (3) nebeneinander angeordneten Schutzleiterscheiben (25) und Rastfußscheiben (24) in dieser Freizone einen Eingriffsraum bei der Abrastung eines Anschlußblocks (3) von der Tragschiene (1) bilden.

20. Modulare Steuerungsanlage nach einem der vorstehenden Ansprüche, **dadurch gekennzeichnet, daß** die im Busleiterbereich (13) frei belassenen, in benachbarten Anschlußblocks (3) nebeneinander angeordneten Schutzleiterscheiben (25) und Rastfußscheiben (24) Betätigungszone für die Trennschieber (14) sind, wobei diese auf der von der Tragschiene (1) abgewandten Seite durch den gesteckten Elektronikmodul (2) verdeckt und erst nach Abnehmen des Elektronikmoduls (2) abrastbar sind.

21. Modulare Steuerungsanlage nach einem der vorstehenden Ansprüche, **dadurch gekennzeichnet, daß** an dem dem feldbusseitigen Ende abgewandten Ende des internen Busleiters (13) eine steckbare Abschlußscheibe (57) mit Abschlußwiderständen (58) vorsehbar ist, die vorzugsweise als Steckschuh mit einer an der internen Busleiterplatine (13) angeordneten, die Abschlußwiderstände (58) tragenden Platine (62) ausführbar ist.

22. Modulare Steuerungsanlage nach einem der vorstehenden Ansprüche, **dadurch gekennzeichnet, daß** jedes Elektronikmodul (2) mindestens je einen steckbaren und lösbaren Steckanschluß (11) zur Verbindung mit den Signalleitern der Initiatoren, Aktoren, Feldgeräte oder dgl. und mit dem internen Busleiter (13) sowie diese Steckanschlüsse verbindende Funktionsleiterplatten (40) enthält.

23. Modulare Steuerungsanlage nach einem der Ansprüche 1, 2 oder 9**, dadurch gekennzeichnet, daß** bei Anschluß passiver Initiatoren/Feldgeräte Vorrichtungen (6) zur Aufnahme von Verteilerleisten entfallen, wobei dann mindestens zwei Signalleiteranschlüsse (8) vorgesehen sind.

24. Modulare Steuerungsanlage nach einem der Ansprüche 1, 2 oder 9, **dadurch gekennzeichnet, daß** bei Anschluß aktiver Initiatoren/Feldgeräte immer mindestens je eine Vorrichtung (6) zur Aufnahme von Verteilerleiste und mindestens je ein Signalleiteranschluß (8) vorgesehen sind.

25. Modulare Steuerungsanlage nach Anspruch 1 oder 2, **dadurch gekennzeichnet, daß** der Elektronikmodul (2) ein mindestens eine Anschlußscheibe (24-27) des mindestens einen Anschlußblocks (3) umgreifendes, veränderbar codiertes und die aneinander gereihten Anschlußscheiben (24-27) stabilisierendes Gehäuse aufweist.

26. Modulare Steuerungsanlage nach einem der Ansprüche 1, 2 oder 25, **dadurch gekennzeichnet, daß** an jeder Anschlußscheibe (24-27) Formelemente, vorzugsweise als federnde Rasthaken (17), zur Verrastung des Elektronikmoduls (2) vorhanden sind und diese beim Aufsetzen des Elektronikmoduls (2) korrespondierende Ausnehmungen (28) in dessen Gehäuse durchdringen, wobei vorzugsweise nur ein Teil der Ausnehmungen (28) mit den Rasthaken (17) zusammenwirkende Rastelementen vorgesehen sind.

27. Modulare Steuerungsanlage nach einem der Ansprüche 1, 2, 25 oder 26, **dadurch gekennzeichnet, daß** an jeder Anschlußscheibe (24-27) ein federnder Rasthaken (58) vorsehbar ist, wobei in einer Reihung der Anschlußscheiben (24-27) eines Anschlußblocks (3) nur einer dieser Rasthaken (58) in eine zugeordnete Ausnehmung am Gehäuse des Elektronikmodules (2) eingreift.

28. Modulare Steuerungsanlage nach einem der Ansprüche 1, 2, 25 oder 26, **dadurch gekennzeichnet, daß** an jeder Anschlußscheibe (24-27) an mindestens einer Führungsfläche (15) für den Elektronikmodul (2) Formelemente, vorzugsweise in Form von T-Nuten oder Teilen von T-Nuten, zur Führung vorgesehen sind, wobei mindestens zwei korrespondierende Formelemente (19) am Gehäuse des Elektronikmoduls (2) eingreifen.

29. Modulare Steuerungsanlage nach einem der Ansprüche 1, 2, oder 25 bis 28, **dadurch gekennzeichnet, daß** das Gehäuse des Elektronikmoduls (2), vorzugsweise durch eine Höhenabstufung (23) der an der offenen Seite angeordneten umlaufenden Kante, nur in einer Orientierung aufsteckbar ist.

30. Modulare Steuerungsanlage nach einem der Ansprüche 1, 2 oder 21, **dadurch gekennzeichnet, daß** bei entferntem Elektronikmodul (2) alle restlichen an einer Tragschiene (1) angeordneten Anschlußblocks (3) voll funktionsfähig sind.

31. Modulare Steuerungsanlage nach Anspruch 1 oder 2, **dadurch gekennzeichnet, daß** eine längenanpaßbare Sammelschiene (55) auf die Schutzleiterscheibe (25) und die letzte Anschlußscheibe (24) des gleichen oder eines weiteren Anschlußblocks (3) aufsteckbar ist, die durch Kontakte der Schutzleiterscheibe (25) elektrischen Anschluß zur Tragschiene (1) hat und an die mittels aufrastbarer Klemmstücke (56) die Schirmungen zugeordneter Anschlußkabel (51) klemmbar sind.

32. Modulare Steuerungsanlage nach einem der Ansprüche 1, 2 oder 9, **dadurch gekennzeichnet, daß** der Leiteranschluß an die Anschlußblocks (3) von der der Tragschiene (1) abgewandten Seite erfolgt und daß das Elektronikmodul (2) ohne Lösen der Verdrahtung abnehmbar ist.

33. Modulare Steuerungsanlage nach Anspruch 1 oder 2, **dadurch gekennzeichnet, daß** große Markierungsflächen durch steckbare Beschriftungsdeckel und/oder schwenkbare Schildträger oberhalb der Verdrahtungsebene vorsehbar sind.

34. Modulare Steuerungsanlage nach einem der Ansprüche 1, 2 oder 9, **dadurch gekennzeichnet, daß** die Versorgungsleiteranschlüsse (7) parallel zur Ebene der Tragschiene (1) auf gleichem Höhenniveau liegen.

35. Modulare Steueranlage anch Anspruch 1, 2 oder 10, **dadurch gekennzeichnet, daß** an mindestens einem Ende einer Vorrichtung (6) zur Aufnahme von Verteilerleisten ein Brückenelement (21) einsteckbar ist, das eine elektrische Weiterleitung des Potentials der mit diesem Brückenelement (21) elektrisch verbindbaren Anschlußelemente (7) an Anschlußelemente (7) einer parallel dazu angeordneten Verteilerleiste herstellt und wie die Anschlußelemente (7) in die Vorrichtung (6) zur Aufnahme von Verteilerleisten rastbar befestigt ist.

36. Modulare Steueranlage nach Anspruch 1, 2 oder 10, **dadurch gekennzeichnet, daß** in die Vorrichtungen (6) zur Aufnahme von Verteilerleisten nicht querverbindende Elemente (61) einsteckbar sind, durch welche in die Verteilerleiste eingespeiste unterschiedliche elektrische Potentiale elektrisch voneinander trennbar sind.

37. Modulare Steuerungsanlage nach einem der vorstehenden Ansprüche, **dadurch gekennzeichnet, daß** die Schutzleiterscheibe ferner Bereiche zum Weiterleiten des Schutzleiterpotentials auf wenigstens eines der Anschlußelemente (7) aufweist.

## Claims

1. A modular control installation for electronic control and automation systems comprising
- at least two connection blocks (3) which can be arranged in a row and clamped on a common mounting rail (1) and each comprise a number of connection plates (24, 25, 26, 27) which can be arranged in a row, and arranged therein supply connections and/or signal conductor connections for associated initiators, actuators, field devices or the like,
- devices for the distribution of electrical potentials within the same connection block (3),
- an internal bus conductor (13) for connecting all connection blocks (3) arranged on the mounting rail (1),
- at least one electronic module (2) for signal conditioning and processing in the connection of initiators, actuators, field devices or the like which can be connected to the signal conductors, to the internal bus conductor (13), and
- a connection module (4) for the connection of the internal bus conductor (13) to an associated field bus,
characterised in that
- arranged within each connection block (3) are at least one protective conductor plate (25), at least one feed-in plate (26) and at least one supply/signal conductor plate (27), whose predetermined functional regions have a structured construction in fixed spatial succession,
- the protective conductor plate (25) has regions for tapping off a protective conductor potential from the mounting rail (1) and for transmitting the protective conductor potential to the electronic module (2),
- the feed-in plate (26) has regions for supplying the electronic module (2) and for supplying distributor links ranged out of connection elements (7) with at least one voltage potential, and
- the supply/signal conductor plate (27) has regions for the cross-distribution of electrical potentials to further connection plates of the same connection block to which associated initiators, actuators, field devices or the like can be connected and regions for the signal conductor connection of the associated initiators, actuators, field devices or the like, wherein the spatial arrangement of the connection plates (24, 25, 26, 27) in all connection blocks (3) occurs in the same sequence.

2. A modular control installation according to claim 1 characterised in that at least one of the connection plates (24-27) also has
- a region for the releasable arrangement of the electronic module (2), and/or
- a region for the arrangement of the internal bus conductor (13).

3. A modular control installation according to claim 1 or claim 2 characterised in that arranged within each connection block (23) are the connection plates (24, 27) in the sequence: a protective conductor plate (25), at least one feed-in plate (26), adjoining the feed-in plate at least one supply/signal conductor plate (27) and possibly a retaining base plate (24).

4. A modular control installation according to one of claims 1, 2 or 3 characterised in that the protective conductor plate (25) has a mechanical fixing and an electrical connection to the mounting rail (1) and a plug connection (11) to the electronic module (2), and that the region for the internal bus conductor (13) is free.

5. A modular control installation according to one of claims 1, 2 or 4 characterised in that the protective conductor plate (23) can be connected with the potential distribution to further connection plates (24, 26, 27) of the same connection block (3).

6. A modular control installation according to claim 1 or claim 2 characterised in that the feed-in plate (26) has a bus conductor region (13) and can be connected with the potential distribution to further connection plates (24-27) of the same connection block (3) and the electronic module (2).

7. A modular control installation according to one of claims 1, 2 or 6 characterised in that the feed-in plate (26) is electrically conductively connected to only one supply/signal conductor plate (27) within the connection block (3).

8. A modular control installation according to one of claims 1, 5 or 6 characterised in that there is only one connection to the electronic module (2) on the feed-in plate (26).

9. A modular control installation according claim 1 characterised in that the supply/signal conductor plate (27) comprises devices (6) for accommodating distributor links, at least one signal conductor terminal (8), the plug connections for the electronic module (11) and the region for the internal bus conductor (13).

10. A modular control installation according to one of claims 1, 2 or 9 characterised in that each device (6) for accommodating distributor links has fixing contours for the connection elements (7) which can be plugged into and retained in the distributor links and which can preferably be coloured and which also provide for cross-distribution.

11. A modular control installation according to one of the preceding claims characterised in that each connection block (3) has at both passage sides of the mounting rail (1) connection plates (24, 25) which have respective retaining bases (9) associated with the mounting rail (1) for mechanical fixing on and/or electrical connection to said mounting rail (1)

12. A modular control installation according to one of claims 1, 2 or 11 characterised in that the retaining base plate (24) has exclusively a mechanical fixing on the mounting rail (1).

13. A modular control installation according to one of claims 1, 2, 11 or 12 characterised in that the retaining base plate (24) can be designed for exclusive connection of a separate protective conductor to the electronic module (2) as a protective conductor plate (25).

14. A modular control installation according to one of claims 1, 2 or 11 to 13 characterised in that the retaining base plate (24) can be designed as a second feed-in plate (26) for the exclusive connection of a digital output module (37) and/or the electronic module (2).

15. A modular control installation according to one of the preceding claims characterised in that when using two protective conductor plates (25) within a connection block (3) they are arranged in the row at the beginning and at the end of the connection block (3).

16. A modular control installation according to one of the preceding claims characterised in that the connections of similar initiators, actuators, field devices or the like can be combined if required in connection blocks (3) of similar connection plates (27).

17. A modular control installation according to one of the preceding claims characterized in that the connections of different initiators, actuators, field devices or the like can be combined if necessary in connection blocks (3) of different connection plates (27).

18. A modular control installation according to claim 1 or claim 2 characterised in that the internal bus conductor (13) comprises bus bar portions which by way of displaceable and latchable separating sliders (14) can be releasably and electrically/mechanically connected to the adjacent bus conductor portions.

19. A modular control installation according to one of the preceding claims characterised in that the protective conductor plates (25) which are left free in the bus conductor region (13) and which are arranged in mutually juxtaposed relationship in adjacent connection blocks (3) and retaining base plates (24) in that free zone form an engagement space upon disengagement of connection block (3) from the mounting rail (1).

20. A modular control installation according to one of the preceding claims characterised in that the protective conductor plates (25) which are left free in the bus conductor region (13) and which are arranged in mutually juxtaposed relationship in adjacent connection blocks (3) and retaining base plates (24) are an actuating zone for the separating sliders (14), wherein they are concealed on the side remote from the mounting rail (1) by the fitted electronic module (2) and are disengageable only after removal of the electronic module (2).

21. A modular control installation according to one of the preceding claims characterised in that a plug-in termination plate (57) with terminal resistors (58) can be provided at the end of the internal bus conductor (13) remote from the field bus end, which termination plate can preferably be in the form of a plug-in shoe with a board (62) which is arranged on the internal bus conductor board (13) and which carries the terminal resistors (58).

22. A modular control installation according to one of the preceding claims characterised in that each electronic module (2) includes at least one respective plug-in and releasable plug connection (11) for connection to the signal conductors of the initiators, actuators, field devices or the like and to the internal bus conductor (13) and functional circuit boards (40) connecting said plug connections.

23. A modular control installation according to one of claims 1, 2 or 9 characterised in that when connecting passive initiators/field devices devices (6) for accommodating distributor links are omitted, in which case then there are provided at least two signal conductor connections (8).

24. A modular control installation according to one of claims 1, 2 or 9 characterised in that when connecting active initiators/field devices there are always provided at least one respective device (6) for accommodating a distributor link and at least one respective signal conductor connection (8).

25. A modular control installation according to clam 1 or claim 2 characterised in that the electronic module (2) has a variably coded casing which embraces at least one connection plate (24-27) of the at least one connection block (3) and which stabilises the connection plates (24-27) which are arranged in a row with each other.

26. A modular control installation according to one of claims 1, 2 or 25 characterised in that provided on each connection plate (24-27) are shaped elements, preferably in the form of resilient retaining hooks (17), for latching of the electronic module (2) and when the electronic module (2) is fitted on said shaped elements pass through corresponding openings (28) in the casing thereof, wherein preferably only some of the openings (28) are provided with retaining elements co-operating with the retaining hooks (17).

27. A modular control installation according to one of claims 1, 2, 25 or 26 characterised in that a resilient retaining hook (58) can be provided on each connection plate (24-27), wherein in a row configuration of the connection plates (24-27) of a connection block (3), only one of said retaining hooks (58) engages into an associated opening on the casing of the electronic module (2).

28. A modular control installation according to one of claims 1, 2, 25 or 26 characterised in that provided on each connection plate (24-27) on at least one guide surface (15) for the electronic module (2) are shaped elements, preferably in the form of T-shaped grooves or parts of T-shaped grooves, for guidance purposes, wherein at least two corresponding shaped elements (19) engage on the casing of the electronic module (2).

29. A modular control installation according to one of claims 1, 2 or 25 to 28 characterised in that the casing of the electronic module (2) can be fitted on only in one orientation, preferably by virtue of a heightwise step (23) of the peripheral edge arranged at the open side.

30. A modular control installation according to one of claims 1, 2 or 21 characterised in that when the electronic module (2) is removed all remaining connection blocks (3) arranged on a mounting rail (1) are fully operational.

31. A modular control installation according to claim 1 or claim 2 characterised in that a collecting bar (55) which can be adapted in respect of length can be fitted on to the protective conductor plate (25) and the last connection plate (24) of the same or a further connection block (3). which by contacts of the protective conductor plate (25) has electrical connection with respect to the mounting rail (1) and to which the shieldings of associated connection cables (51) can be clamped by means of clamping portions (56) which can be latched thereon.

32. A modular control installation according to one of claims 1, 2 or 9 characterised in that the conductor connection to the connection blocks (3) is effected from the side remote from the mounting rail (1) and that the electronic module (2) is removable without releasing the wiring.

33. A modular control installation according to claim 1 or claim 2 characterised in that large marking surfaces can be provided by push-on labelling covers and/or pivotable identification plate carriers above the wiring plane.

34. A modular control installation according to one of claims 1, 2 or 9 characterised in that the supply conductor connections (7) are disposed parallel to the plane of the mounting rail (1) at the same heightwise level.

35. A modular control installation according to claim 1, claim 2 or claim 10 characterised in that a bridge element (21) can be inserted at at least one end of a device (6) for accommodating distributor links, which hridge element provides for electrical transmission of the potential of the connection elements (7) which can be electrically connected to said bridge element (21) to connection elements (7) of a distributor link arranged parallel thereto and like the connection elements (7) is fixed latchably into the device (6) for accommodating distributor links.

36. A modular control installation according to claim 1, claim 2 or claim 10 characterised in that non-cross-connecting elements (61) can be plugged into the devices (6) for accommodating distributor links, by means of which elements (61) different electrical potentials which are fed into the distributor link can be electrically separated from each other.

37. A modular control installation according to one of the preceding claims characterised in that the protective conductor plate also has regions for transmitting the protective conductor potential to at least one of the connection elements (7).

## Revendications

1. Installation de commande modulaire pour systèmes électroniques de commande et d'automatisation comportant
- au moins deux blocs de jonction (3), à serrer et à joindre les uns aux autres sur un rail de support (1) commun, constitués chacun d'un nombre de disques de jonction (24, 25, 26, 27) à joindre les uns aux autres et de bornes d'alimentation et/ou de bornes de lignes de signaux, disposées à l'intérieur, pour des initiateurs, des actionneurs, des appareils de champ ou similaires,
- des dispositifs de distribution de potentiels électriques à l'intérieur de ce même bloc de jonction (3),
- une ligne de bus interne (13) pour la liaison de tous les blocs de jonction (3) disposés sur le rail de support (1),
- au moins un module électronique (2) pour le traitement des signaux lors de la liaison entre des initiateurs, actionneurs, appareils de champ ou similaires à raccorder aux lignes de signaux, avec la ligne de bus interne (13),
- un module de jonction (4) pour la connexion de la ligne de bus interne (13) à un bus de champ correspondant,
caractérisée en ce que
- à l'intérieur de chaque bloc de jonction (3) sont disposés au moins un disque conducteur de protection (25), au moins un disque d'alimentation (26) et au moins un disque de ligne d'alimentation/ligne de signaux (27) dont les zones de fonctionnement pré-établies présentent un assemblage structuré sous forme de succession ferme s'étendant dans l'espace,
- le disque conducteur de protection (25) présente des zones pour le prélèvement d'un potentiel du conducteur de protection, à partir du rail de support (1) et pour la transmission du potentiel du conducteur de protection au module électronique (2),
- le disque d'alimentation (26) présente des zones pour l'alimentation du module électronique (2) et pour l'alimentation de barres de distribution montées en série à partir d'éléments de jonction (7), avec au moins un potentiel de tension et
- le disque de ligne d'alimentation/ligne de signaux (27) présente des zones pour la distribution transversale de potentiels électriques à d'autres disques de jonction de ce même bloc de jonction, auxquels des initiateurs, actionneurs, appareils de champ ou similaires correspondants peuvent être raccordés, ainsi que des zones pour la connexion de lignes de signaux des initiateurs, actionneurs, appareils de champ ou similaires correspondants, la disposition dans l'espace des disques de jonction (24, 25, 26, 27) s'effectuant dans le même ordre dans tous les blocs de jonction (3).

2. Installation de commande modulaire selon la revendication 1, caractérisée en ce qu'au moins l'un des disques de jonction (24 à 27) comporte en outre:
- une zone pour la disposition non permanente du module électronique (2) et/ou
- une zone pour la disposition de la ligne de bus interne (13).

3. Installation de commande modulaire selon la revendication 1 ou 2, 1 caractérisée en ce qu'à l'intérieur de chaque bloc de jonction (3) sont disposés les disques de jonction (24 à 27) dans cet ordre: un disque conducteur de protection (25), au moins un disque d'alimentation (26), à la suite du disque d'alimentation au moins un disque de ligne d'alimentation/ligne de signaux (27) et éventuellement un disque de pied d'encliquetage (24).

4. Installation de commande modulaire selon l'une des revendications 1 2 ou 3, caractérisée en ce que le disque conducteur de protection (25) présente une fixation mécanique sur le rail de support (1) et une connexion électrique avec le rail de support (1), une connexion à fiches (11) pour le module électronique (2) et en ce que la zone destinée à la ligne de bus interne (13) est libre.

5. Installation de commande modulaire selon l'une des revendications 1, 2 ou 4, caractérisée en ce que le disque conducteur de protection (23) avec la distribution de potentiel peut être relié à d'autres disques de jonction (24, 26, 27) du même bloc de jonction (3).

6. Installation de commande modulaire selon la revendication 1 ou 2, caractérisée en ce que le disque d'alimentation (26) présente une zone de ligne de bus (13) et peut être relié à la distribution de potentiels à d'autres disques de jonction (24 à 27) du même bloc de jonction (3) ainsi qu'au module électronique (2),

7. Installation de commande modulaire selon l'une des revendications 1 2 ou 6, caractérisée en ce que le disque d'alimentation (26) est relié de manière électriquement conductrice à seulement un disque de ligne d'alimentation/ligne de signaux (27) à l'intérieur de bloc de jonction (3).

8. Installation de commande modulaire selon l'une des revendications 1 5 ou 6, caractérisée en ce que sur le disque d'alimentation (26) il n'existe qu'une liaison avec le module électronique (2).

9. Installation de commande modulaire selon la revendication 1, caractérisée en ce que le disque de ligne d'alimentation/ligne de signaux (27) est constitué de dispositifs (6) destinés à recevoir des barres de distribution, au moins une borne de lignes de signaux (8) les connexions à fiches pour le module électronique (11) et la zone pour la ligne de bus interne (13).

10. Installation de commande modulaire selon l'une des revendications 1 2 ou 9, caractérisée en ce que chaque dispositif (6) présente, pour recevoir des barres de distribution, des contours de fixation pour des éléments de jonction (7), également pour la distribution transversale, qui peuvent être enfichés et encliquetés dans les barres de distribution et qui peuvent de préférence être colorés.

11. Installation de commande modulaire selon l'une des revendications précédentes, caractérisée en ce que chaque bloc de jonction (3) présente sur les deux côtés de passage du rail de support (1), des disques de jonction (24, 25) qui présentent des pieds d'encliquetage (9) affectés au rail de support (1) pour le serrage mécanique sur ce rail de support (1) et/ou la liaison électrique avec ce rail de support (1).

12. Installation de commande modulaire selon l'une des revendications 1, 2 ou 11, caractérisée en ce que le disque de pied d'encliquetage (24) présente exclusivement une fixation mécanique sur le rail de support (1).

13. Installation de commande modulaire selon l'une des revendications 1, 2 ou 12, caractérisée en ce que le disque de pied d'encliquetage (24) peut être réalisé en tant que disque conducteur de protection (25) pour la connexion exclusive d'un conducteur de protection séparé au module électronique (2).

14. Installation de commande modulaire selon l'une des revendications 1, 2 ou 11 à 13, caractérisée en ce que le disque de pied d'encliquetage (24) peut être réalisé sous la forme d'un deuxième disque d'alimentation (26) pour la connexion exclusive d'un module de sortie numérique (37) et/ou du module électronique (2).

15. Installation de commande modulaire selon l'une des revendications précédentes, caractérisée en ce que dans le cas où l'on utilise deux disques conducteurs de protection (25) à l'intérieur d'un bloc de jonction (3), ceux-ci sont disposés en série, au début et à la fin du bloc de jonction (3).

16. Installation de commande modulaire selon l'une des revendications précédentes, caractérisée en ce que les bornes d'initiateurs, actionneurs, appareils de champ ou similaires de même type peuvent être réunies au besoin dans ces blocs de jonction (3) de disques de jonction (27) de même type.

17. Installation de commande modulaire selon l'une des revendications précédentes, caractérisée en ce que les bornes d'initiateurs, actionneurs, appareils de champ ou similaires différents peuvent au besoin être réunies dans des blocs de jonction (3) de disques de jonction (27) différents.

18. Installation de commande modulaire selon l'une des revendications 1 ou 2, caractérisée en ce que la ligne de bus interne (13) est constituée de pièces de rail de bus, qui peuvent être reliées de manière non permanente et électro-mécaniquement aux pièces de ligne de bus voisines, par des coulisseaux de séparation (14) qui peuvent coulisser et s'encliqueter.

19. Installation de commande modulaire selon l'une des revendications précédentes, caractérisée en ce que les disques conducteurs de protection (25) laissés libres dans la zone de la ligne de bus (13) et juxtaposés dans des blocs de jonction (3) voisins et des disques de pied d'encliquetage (24) dans cette zone libre forment un volume d'intervention lors du décrochage d'un bloc de jonction (3) du rail de support (1).

20. Installation de commande modulaire selon l'une des revendications précédentes, caractérisée en ce que les disques conducteurs de protection (25) laissés libres dans la zone de la ligne de bus (13) et juxtaposés dans des blocs de jonction (3) voisins et des disques de pied d'encliquetage (24) constituent une zone d'actionnement pour les coulisseaux de sectionnement (14), ceux-ci étant dissimulés sur le côté opposé au rail de support (1) par le module électronique (2) enfiché et ne peuvent être décrochés qu'après enlèvement du module électronique (2).

21. Installation de commande modulaire selon l'une des revendications précédentes, caractérisée en ce qu'à l'extrémité de la ligne de bus interne (13) opposée à l'extrémité côté bus de champ, on peut prévoir un disque de fermeture (57) enfichable avec des résistances de fermeture (58), qui peut être réalisé de préférence sous la forme d'un patin d'enfichage avec une platine (62) qui est disposée sur la platine interne (13) de la ligne de bus et qui porte les résistances de fermeture (58).

22. Installation de commande modulaire selon l'une des revendications précédentes, caractérisée en ce que chaque module électronique (2) contient au moins une connexion à fiches (11) enfichable et séparable pour la liaison avec les lignes de signaux des initiateurs, actionneurs, appareils de champ ou similaires et avec la ligne de bus interne (13) ainsi que des plaques de lignes de fonction (40) reliant ces connexions à fiches.

23. Installation de commande modulaire selon l'une des revendications 1, 2 ou 9, caractérisée en ce que dans le cas de la connexion d'initiateurs/appareils de champ passifs, des dispositifs (6) destinés à recevoir des barres de distribution sont supprimés, auquel cas au moins deux bornes de lignes de signaux (8) sont alors prévues.

24. Installation de commande modulaire selon l'une des revendications 1 à 5 ou 13, caractérisée en ce que dans le cas de la connexion d'initiateurs/appareils de champ actifs, au moins un dispositif (6) est toujours prévu pour recevoir des barres de distribution et au moins une borne de lignes de signaux (8).

25. Installation de commande modulaire selon l'une des revendications 1 ou 2, caractérisée en ce que le module électronique (2) comporte un boîtier qui entoure au moins un disque de jonction (24 à 27) du ou des blocs de jonction (3), qui est codé de manière variable et qui stabilise les disques de jonction (24 à 27) joints les uns aux autres.

26. Installation de commande modulaire selon l'une des revendications 1, 2 ou 5, caractérisée en ce que sur chaque disque de jonction (24 à 27) se trouvent des éléments profilés, de préférence sous la forme de crochets d'encliquetage (17) élastiques, pour l'accrochage du module électronique (2), qui, lors de la mise en place du module électronique (2), traversent des évidements (28) correspondants pratiqués dans son boîtier, de préférence une partie seulement des évidements (28) étant prévue avec des éléments d'encliquetage coopérant avec les crochets d'encliquetage (17) élastiques.

27. Installation de commande modulaire selon l'une des revendications 1, 2, 25 ou 26, caractérisée en ce que l'on peut prévoir sur chaque disque de jonction (24 à 27) un crochet d'encliquetage (58) élastique, dans une rangée des disques de jonction (24 à 27) d'un bloc de jonction (3), seul l'un de ces crochets d'encliquetage (58) s'engageant dans un évidement correspondant du boîtier du module électronique (2).

28. Installation de commande modulaire selon l'une des revendications 1, 2, 25 ou 26, caractérisée en ce que sur chaque disque de jonction (24 à 27), sur au moins une surface de guidage (15) du module électronique (2), sont prévus pour le guidage des éléments profilés, des éléments profilés, de préférence sous la forme de rainures en T ou de parties de rainures en T, dans lesquels s'engagent au moins deux éléments profilés (19) correspondants du boîtier du module électronique (2).

29. Installation de commande modulaire selon l'une des revendications 1, 2 ou 25 à 28, caractérisée en ce que le boîtier du module électronique (2) peut être enfiché uniquement suivant une orientation, de préférence par un échelonnement (23) de la hauteur du bord périphérique disposé sur le côté ouvert.

30. Installation de commande modulaire selon l'une des revendications 1 à 5 ou 25, caractérisée en ce que lorsque le module électronique (2) est enlevé, tous les blocs de jonction (3) restants qui sont disposés sur un rail de support (1) sont pleinement en état de fonctionner.

31. Installation de commande modulaire selon la revendication 1 ou 2, caractérisée en ce qu'un rail collecteur (55) de longueur adaptable peut être emboîté sur le disque conducteur de protection (25) et sur le dernier disque de jonction (24) du même bloc de jonction (3) ou d'un autre bloc de jonction (3), qui sont en liaison électrique avec le rail de support (1), par des contacts du disque conducteur de protection, et qui peuvent être serrés sur le câble de jonction (51) associé aux blindages, au moyen de pièces de serrage (56) à clipser dessus.

32. Installation de commande modulaire selon l'une des revendications 1 à 5 ou 13, caractérisée en ce que la connexion de lignes aux blocs de jonction (3) s'effectue à partir du côté tourné à l'opposé du rail de support (1) et en ce que le module électronique (2) peut être enlevé sans suppression du câblage.

33. Installation de commande modulaire selon la revendication 1 ou 2, caractérisée en ce que de grandes surfaces de marquage peuvent être prévues par des couvercles emboîtables avec inscriptions et/ou des porte-étiquettes pivotants, au-dessus du plan de câblage.

34. Installation de commande modulaire selon l'une des revendications 1, 2 ou 9, caractérisée en ce que les bornes de ligne d'alimentation (7) sont parallèles au plan du rail de support (1) à un même niveau de hauteur.

35. Installation de commande modulaire selon la revendication 1, 2 ou 10, caractérisée en ce qu'à au moins une extrémité d'un dispositif (6) destiné à recevoir des barres de distribution, on peut enficher un élément en pont (21) qui assure une transmission électrique du potentiel des éléments de jonction (7), à relier électriquement à cet élément en pont (21), à des éléments de jonction (7) d'une barre de distribution parallèle à cet élément en pont et en ce que les éléments de jonction (7) sont fixés de manière à pouvoir s'encliqueter dans le dispositif (6) destiné à recevoir des barres de distribution.

36. Installation de commande modulaire selon l'une des revendications 1 à 5 ou 14, caractérisée en ce que dans les dispositifs (6) destinés à recevoir des barres de distribution on peut enficher des éléments (61) qui n'assurent pas une liaison transversale, par lesquels des potentiels électriques différents alimentés dans un barre de distribution, peuvent être électriquement séparés les uns des autres.

37. Installation de commande modulaire selon l'une des revendications précédentes, caractérisée en ce que le disque conducteur de protection présente en outre des zones pour la transmission du potentiel du conducteur de protection à au moins l'un des éléments de jonction (7).
